# EUROPEAN PATENT APPLICATION

(11) **EP 4 589 662 A1**
(43) Date of publication of application: **23.07.2025**
(21) Application number: 23916642.4
(22) Date of filing: 16.01.2023
(51) Int. Cl.: H01L 27/15

(54) **DISPLAY PANEL, DISPLAY APPARATUS, AND TILED DISPLAY APPARATUS**

(71) Applicant: BOE Technology Group Co., Ltd., Beijing 100015 (CN); BOE MLED Technology Co., Ltd., Beijing 100176 (CN)
(72) Inventor: WANG, Lili, Beijing 100176 (CN); CHU, Yutian, Beijing 100176 (CN); LIU, Chao, Beijing 100176 (CN); ZHAO, Jingping, Beijing 100176 (CN); ZHAI, Ming, Beijing 100176 (CN); QI, Qi, Beijing 100176 (CN)
(74) Representative: Hoffmann Eitle
(86) International application number: PCT/CN2023/072359
(87) International publication number: WO 2024/152150

(57) **Abstract**

A display panel, a display apparatus, and a tiled display apparatus. The display panel comprises a substrate, a plurality of electronic elements, a plurality of first electrodes, and a plurality of connection wires. The substrate comprises a first primary surface and a second primary surface opposite to one another, and a plurality of side surfaces connecting the first primary surface and the second primary surface, at least one of the plurality of side surfaces being a selected side surface. The plurality of connection wires are arranged in parallel and at intervals; each of the plurality of connection wires comprises, successively connected, a first wire segment, a second wire segment, and a third wire segment; the third wire segments are arranged on the second primary surface, and each third wire segment comprises a binding part and a non-binding part, the binding part being further than the non-binding part from the selected side surface; the maximum size of the binding part of a third wire segment along a direction perpendicular to the extension direction of the binding part is smaller than the maximum size of the non-binding part along a direction perpendicular to the extension direction of the non-binding part, and the binding parts of a plurality of third wire segments are used for binding a circuit board.

## Description

### TECHNICAL FIELD

The present disclosure relates to the field of display technologies, and in particular, to a display panel, a display device, and a tiled display device.

### BACKGROUND

Mini light-emitting diode (Mini LED) display devices and micro light-emitting diode (Micro LED) display devices have self-luminous display characteristics. Their advantages include all-solid-state, long life, high brightness, low power consumption, small volume, ultra-high resolution, etc.

Due to the difficulty of the mass transfer process of Mini LED chips in Mini LED display devices and Micro LED chips in Micro LED display devices, it is relatively difficult to directly prepare large-sized display devices. Therefore, multiple small-sized Mini LED display devices or multiple small-sized Micro LED display devices are usually spliced together to achieve the manufacturing of a large-sized display panel.

### SUMMARY

In an aspect, a display panel is provided, which includes a substrate, a plurality of electronic elements, a plurality of first electrodes, and a plurality of connection lines. The substrate includes a first main surface and a second main surface opposite each other, and multiple side surfaces connecting the first main surface and the second main surface, where at least one side surface of the multiple side surfaces is a selected side surface. The plurality of electronic elements are disposed on the first main surface of the substrate. The plurality of first electrodes are disposed on the first main surface of the substrate. The plurality of first electrodes are closer to the selected side surface than the plurality of electronic elements, and the plurality of first electrodes are electrically connected to the plurality of electronic elements. The plurality of connection lines are arranged side by side at intervals, where each connection line of the plurality of connection lines includes a first line segment, a second line segment and a third line segment that are connected in sequence; the first line segment is disposed on the first main surface, and electrically connected to one of the plurality of first electrodes, the second line segment is disposed on the selected side surface, and the third line segment is disposed on the second main surface; the third line segment includes a bonding portion and a non-bonding portion, and the bonding portion is farther away from the selected side surface relative to the non-bonding portion; and bonding portions of a plurality of third line segments are used for bonding a circuit board. A maximum dimension of the bonding portion of the third line segment along a direction perpendicular to an extension direction of the bonding portion is less than a maximum dimension of the non-bonding portion along a direction perpendicular to an extension direction of the non-bonding portion; and/or in the plurality of third line segments, a bonding portion of at least one third line segment includes at least two sub-bonding portions, and at least one sub-bonding portion of the two sub-bonding portions is connected to a non-bonding portion of the third line segment.

In some embodiments, for the third line segment, a difference between the maximum dimension of the bonding portion along the direction perpendicular to the extension direction thereof and the maximum dimension of the non-bonding portion along the direction perpendicular to the extension direction thereof is in a range of 20 µm to 50 µm, inclusive.

In some embodiments, a dimension of the bonding portion in a first direction is greater than or equal to 80 µm, the first direction being a direction in which the plurality of third line segments are arranged.

In some embodiments, a distance between two adjacent bonding portions is in a range of 40 µm to 110 µm, inclusive.

In some embodiments, two opposite side edges of a portion, connected to the bonding portion, of the non-bonding portion in the first direction are a first side edge and a second side edge; two opposite sides of the bonding portion in the first direction are a third side edge and a fourth side edge; and the first side edge and the third side edge are located at a same side, and the second side edge and the fourth side edge are located at a same side; and a distance between the first side edge and the third side edge is equal to a distance between the second side edge and the fourth side edge.

In some embodiments, the bonding portion of the third line segment includes a first sub-bonding portion and a second sub-bonding portion, the first sub-bonding portion is connected to the non-bonding portion, and the first sub-bonding portion and the second sub-bonding portion are provided with a first isolation region therebetween; and an area of the first sub-bonding portion is greater than an area of the second sub-bonding portion.

In some embodiments, the bonding portions of the plurality of third line segments each include a first sub-bonding portion and a second sub-bonding portion, a first isolation region corresponding to each of the bonding portions extends along a first direction, and a plurality of first isolation regions have a same dimension in a second direction, which is less than dimensions of the plurality of first isolation regions and the selected side surface, where the second direction is perpendicular to the first direction.

In some embodiments, a dimension of the first isolation region in the second direction is in a range of 15 µm to 30 µm, inclusive.

In some embodiments, a ratio of a dimension of the second sub-bonding portion in a second direction to a dimension of the first sub-bonding portion in the second direction is in a range of 0.08 to 0.1, inclusive, the second direction being perpendicular to a first direction.

In some embodiments, the circuit board includes a plurality of bonding electrodes arranged at intervals along a first direction, and each bonding portion is connected to at least one bonding electrode; and a dimension of the bonding portion in the first direction is greater than or equal to 150 µm, and the bonding portion is connected to two adjacent bonding electrodes of the circuit board.

In some embodiments, the bonding portion of the third line segment includes a third sub-bonding portion and a fourth sub-bonding portion, the third sub-bonding portion and the fourth sub-bonding portion are provided with a second isolation region therebetween, and the third sub-bonding portion and the fourth sub-bonding portion are both connected to the non-bonding portion; and the third sub-bonding portion and the fourth sub-bonding portion are connected to the two bonding electrodes respectively.

In some embodiments, a distance between the two adjacent bonding portions is greater than or equal to a dimension of the second isolation region in the first direction.

In some embodiments, a dimension of the second isolation region in the first direction is in a range of 10 µm to 30 µm, inclusive.

In some embodiments, for a bonding electrode and a sub-bonding portion connected in correspondence, a dimension of the bonding electrode in the first direction is less than or equal to a dimension of the sub-bonding portion in the first direction; and the sub-bonding portion is the third sub-bonding portion or the fourth sub-bonding portion.

In some embodiments, dimensions of the third sub-bonding portion and the fourth sub-bonding portion in the first direction are equal.

In some embodiments, a ratio of a dimension of the bonding portion of the third line segment in a second direction to a dimension of the third line segment in the second direction is in a range of 0.4 to 0.5, inclusive.

In some embodiments, the third line segment includes a first sub-line segment, a second sub-line segment and a third sub-line segment that are connected in sequence, and the first sub-line segment is proximate to the selected side surface; first sub-line segments of the plurality of connection lines are arranged at intervals along a first direction, and third sub-line segments of the plurality of connection lines are arranged at intervals along the first direction; an extension direction of the first sub-line segment intersects an extension direction of the second sub-line segment, and the extension direction of the second sub-line segment intersects an extension direction of the third sub-line segment; and the first sub-line segment and the second sub-line segment are connected through a first connection portion, and the second sub-line segment and the third sub-line segment are connected through a second connection portion; the bonding portion is the third sub-line segment; and the non-bonding portion is the first sub-line segment, the first connection portion, the second sub-line segment, and the second connection portion; and a boundary line of an orthographic projection of the second connection portion on the second main surface is in a shape of a curve.

In another aspect, a display device is provided, which includes the display panel described in any of the above embodiments; and a driving circuit board, the driving circuit board being disposed on the second main surface of the substrate of the display panel, and electrically connected to a circuit board and the plurality of connection lines of the display panel.

In yet another aspect, a tiled display device is provided, which includes a plurality of display devices each described in any of the above embodiments, the plurality of display devices being tiled and assembled.

In still another aspect, a manufacturing method of a display panel is provided, which includes:
providing a substrate, the substrate including a first main surface and a second main surface opposite each other, and multiple side surfaces connecting the first main surface and the second main surface, where at least one side surface of the multiple side surfaces is a selected side surface; forming a plurality of first electrodes on the first main surface of the substrate; forming a plurality of connection lines on the first main surface, the second main surface and the selected side surface of the substrate, where the plurality of connection lines are arranged side by side at intervals; each connection line of the plurality of connection lines includes a first line segment, a second line segment and a third line segment that are connected in sequence; the first line segment is disposed on a side of the first main surface proximate to the selected side surface, and electrically connected to one of the plurality of first electrodes, the second line segment is disposed on the selected side surface, and the third line segment is disposed on the second main surface; and the third line segment includes a bonding portion and a non-bonding portion, and the bonding portion is farther away from the selected side surface relative to the non-bonding portion; and bonding a circuit board, the circuit board being electrically connected to third line segments of the plurality of connection lines; where a maximum dimension of the bonding portion of the third line segment in a direction perpendicular to an extension direction of the bonding portion is less than a maximum dimension of the non-bonding portion in a direction perpendicular to an extension direction of the non-bonding portion, and a first direction is a direction in which the plurality of third line segments are arranged; and/or in the plurality of third line segments, a bonding portion of at least one third line segment includes at least two sub-bonding portions, and at least one sub-bonding portion of the two sub-bonding portions is connected to a non-bonding portion of the third line segment.

### BRIEF DESCRIPTION OF THE DRAWINGS

In order to describe technical solutions in the present disclosure more clearly, the accompanying drawings to be used in some embodiments of the present disclosure will be introduced briefly; obviously, the accompanying drawings to be described below are merely drawings of some embodiments of the present disclosure, and a person of ordinary skill in the art can obtain other drawings according to those drawings. In addition, the accompanying drawings in the following description may be regarded as schematic diagrams, but are not limitations on actual sizes of products, actual processes of methods and actual timings of signals involved in the embodiments of the present disclosure.
FIG. 1 is a planar structural diagram of a display surface of a display panel provided by some embodiments;
FIG. 2 is a sectional structural diagram of the display panel provided in FIG. 1 along the section line CC, provided by some embodiments;
FIG. 3A is a structural diagram of a second surface of a display panel, provided by some embodiments;
FIG. 3B is a structural diagram of a second surface of a display panel, provided by some embodiments;
FIG. 3C is an enlarged structural diagram of a third line segment of a display panel, provided by some embodiments;
FIG. 4A is a structural diagram of a second surface of a display panel, provided by some embodiments;
FIG. 4B is an enlarged structural diagram of a second surface of a display panel, provided by some embodiments;
FIG. 5A is a structural diagram of a second surface of a display panel, provided by some embodiments;
FIG. 5B is an enlarged structural diagram of a second surface of a display panel, provided by some embodiments;
FIG. 5C is another enlarged structural diagram of a second surface of a display panel, provided by some embodiments;
FIG. 6A is a structural diagram of a second surface of a display panel, provided by some embodiments;
FIG. 6B is an enlarged structural diagram of a second surface of a display panel, provided by some embodiments;
FIG. 7A is a structural diagram of a second surface of a display panel, provided by some embodiments;
FIG. 7B is an enlarged structural diagram of a second surface of a display panel, provided by some embodiments;
FIG. 7C is a structural diagram of a second surface of a display panel, provided by some embodiments;
FIG. 7D is an enlarged structural diagram of a second surface of a display panel, provided by some embodiments;
FIG. 7E is a structural diagram of a second surface of a display panel, provided by some embodiments;
FIG. 7F is an enlarged structural diagram of a second surface of a display panel, provided by some embodiments;
FIG. 8A is a structural diagram of a second surface of a display panel, provided by some embodiments;
FIG. 8B is a structural diagram of a second surface of a display panel, provided by some embodiments;
FIG. 8C is a structural diagram of a second surface of a display panel, provided by some embodiments;
FIG. 9 is a structure of a display device, provided by some embodiments of the present disclosure;
FIG. 10 is structural diagram of another display device, provided by some embodiments of the present disclosure;
FIG. 11 is a planar structural diagram of a tiled display device, provided by some embodiments of the present disclosure; and
FIG. 12 is a flow chart of a manufacturing method of a display panel, provided by some embodiments of the present disclosure.

### DETAILED DESCRIPTION

The technical solutions in some embodiments of the present disclosure will be described clearly and completely in combination with the accompanying drawings; obviously, the described embodiments are merely some but not all embodiments of the present disclosure. All other embodiments obtained by a person of ordinary skill in the art based on embodiments provided by the present disclosure shall be included in the protection scope of the present disclosure.

Unless the context requires otherwise, throughout the specification and the claims, the term "comprise" and other forms thereof such as the third-person singular form "comprises" and the present participle form "comprising" are construed as an open and inclusive meaning, i.e., "including, but not limited to." In the description of the specification, the terms such as "one embodiment," "some embodiments," "exemplary embodiments," "example," "specific example," or "some examples" are intended to indicate that specific features, structures, materials, or characteristics related to the embodiment(s) or example(s) are included in at least one embodiment or example of the present disclosure. Schematic representations of the above terms do not necessarily refer to the same embodiment(s) or example(s). In addition, the specific features, structures, materials, or characteristics may be included in any one or more embodiments or examples in any suitable manner.

Hereinafter, the terms "first," "second," etc., are used for descriptive purposes only, and are not to be construed as indicating or implying a relative importance or implicitly indicating a number of indicated technical features. Thus, features defined by "first," "second," etc., may explicitly or implicitly include one or more of the features. In the description of the embodiments of the present disclosure, the term "a/the plurality of (multiple)" means two or more unless otherwise specified.

In the description of some embodiments, the expressions "coupled," "connected," and derivatives thereof may be used. The term "connected" should be understood in a broad sense. For example, the term "connected" may represent a fixed connection, a detachable connection, or a one-piece connection, or may represent a direct connection, or may represent an indirect connection through an intermediate medium. The term "coupled," for example, indicates that two or more components are in direct physical or electrical contact with each other. The term "coupled" or "communicatively coupled" may also mean that two or more components are not in direct contact with each other but still cooperate or interact with each other. The embodiments disclosed herein are not necessarily limited to the content herein.

The phrase "at least one of A, B, and C" has the same meaning as the phrase "at least one of A, B, or C," both including the following combinations of A, B, and C: only A, only B, only C, a combination of A and B, a combination of A and C, a combination of B and C, and a combination of A, B, and C.

The phrase "A and/or B" includes the following three combinations: only A, only B, and a combination of A and B.

The use of the phrase "applicable to" or "configured to" herein means an open and inclusive expression, which does not exclude devices that are applicable to or configured to perform additional tasks or steps.

The term "about," "substantially," or "approximately" as used herein includes a stated value and an average value within an acceptable range of deviation of a particular value determined by a person of ordinary skill in the art, considering measurement in question and errors associated with measurement of a particular quantity (i.e., limitations of a measurement system).

The term such as "parallel," "perpendicular," or "equal" as used herein includes a stated condition and a condition similar to the stated condition. A range of the similar condition is within an acceptable deviation range, and the acceptable deviation range is determined by a person of ordinary skill in the art, considering measurement in question and errors associated with measurement of a particular quantity (i.e., the limitations of a measurement system). For example, the term "parallel" includes absolute parallelism and approximate parallelism, and an acceptable range of deviation of the approximate parallelism may be, for example, a deviation within 5°; the term "perpendicular" includes absolute perpendicularity and approximate perpendicularity, and an acceptable range of deviation of the approximate perpendicularity may also be, for example, a deviation within 5°; and the term "equal" includes absolute equality and approximate equality, and an acceptable range of deviation of the approximate equality may be a difference between two equals being less than or equal to 5% of either of the two equals.

It will be understood that, when a layer or element is referred to as being on another layer or substrate, it may be that the layer or element is directly on the another layer or substrate, or it may be that intervening layer(s) exist between the layer or element and the another layer or substrate.

Exemplary embodiments are described herein with reference to sectional views and/or planar views that are schematic illustrations of idealized embodiments. In the accompanying drawings, thicknesses of layers and areas of regions are enlarged for clarity. Thus, variations in shape with respect to the accompanying drawings due to, for example, manufacturing technologies and/or tolerances may be envisaged. Therefore, the exemplary embodiments should not be construed as being limited to the shapes of the regions shown herein, but including shape deviations due to, for example, manufacturing. For example, an etched region shown to have a rectangular shape generally has a curved feature. Therefore, the regions shown in the accompanying drawings are schematic in nature, and their shapes are not intended to show actual shapes of the regions in a device, and are not intended to limit the scope of the exemplary embodiments.

In order to improve product reliability and reduce transportation and maintenance costs, large-sized display devices each may be assembled by tiling multiple small-sized display devices.

In order to avoid the fragmentation of display images caused by tiling, it is necessary to reduce a frame size of a single small-sized display device and reduce a width of the tiling seam. The small-sized display device includes a display panel. For example, lines located on a side of a display surface of the display panel may be connected to a circuit board provided on a side of a non-display surface of the display panel through connecting leads, so that in a case where multiple small-sized display devices are tiled to form a large-sized display device, a distance between adjacent small-sized display devices may be reduced, thereby improving the display quality of the large-sized display device formed by tiling the multiple small-sized display devices.

At present, during the manufacturing process of mini light-emitting diode (Mini LED) and micro light-emitting diode (Micro LED) display panels, if there exist foreign matters in a region where the display panel is bonded to the circuit board, the circuit board needs to be re-bonded to ensure the reliability of the bonding connection. During the re-bonding process, it is necessary to first remove the circuit board that has been bonded to the display panel, and then clean bonding electrodes of the circuit board and surfaces of electrodes connected to the circuit board (for example, wipe them with alcohol), and finally re-bond the circuit board to the display panel again. However, since the circuit board and the display panel are bonded and connected through an anisotropic conductive film (ACF), the sticky anisotropic conductive film will adhere to the metal electrodes during the process of removing the circuit board, to make some portions of the metal electrodes fall off, causing certain damage to the metal electrodes; and if an area of a portion falling off is too large, it will cause an open circuit and affect the quality of the product.

In light of this, some embodiments of the present disclosure provide a display panel that solves at least defects caused by the metal electrodes being affected and falling off during the process of re-bonding the circuit board, and effectively solves at least abnormality of circuit disconnection, thereby improving the production efficiency of display panels, further improving the yield and quality of display products.

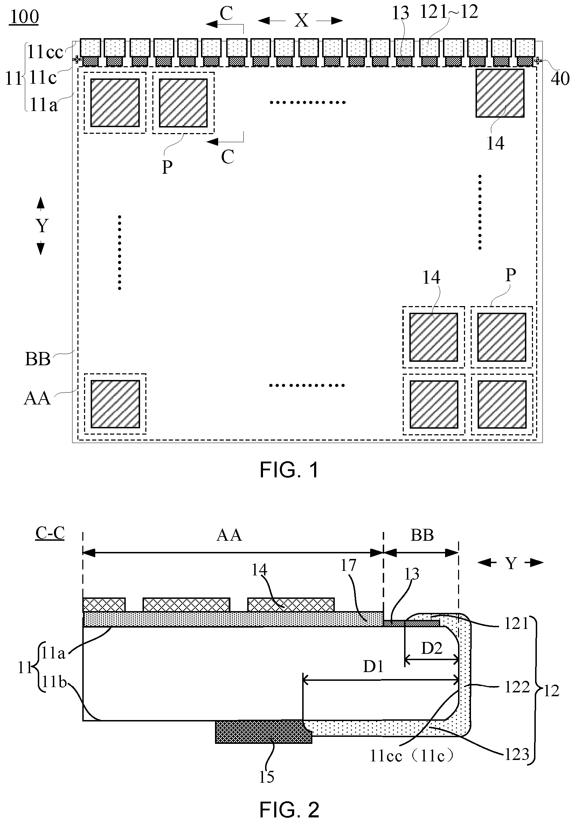

In some embodiments of the present disclosure, FIG. 1 is a planar structural diagram of a display panel 100, and FIG. 2 is a sectional structural diagram of the display panel 100 shown in FIG. 1 along the section line CC.

As shown in FIG. 1, some embodiments of the present disclosure provide a display panel 100. The display panel 100 includes a display area AA and a peripheral area BB provided at least on one side of the display area AA. For example, the peripheral area BB may be located on one, two or three sides of the display area AA. Alternatively, the peripheral area BB may be arranged around the display area AA.

In some embodiments, as shown in FIGS. 1 and 2, the display panel 100 includes a substrate 11, a plurality of connection lines 12, a plurality of first electrodes 13, and a plurality of electronic elements 14. The substrate 11 includes a first main surface 11a and a second main surface 11b opposite each other, and multiple side surfaces 11c connecting the first main surface 11a and the second main surface 11b. At least one side surface 11c of the multiple side surfaces 11c of the substrate 11 is a selected side surface 11cc. The plurality of first electrodes 13 and the plurality of electronic elements 14 are disposed on the first main surface 11a of the substrate 11. The plurality of first electrodes 13 are arranged along a first direction X. The plurality of first electrodes 13 are closer to the selected side surface 11cc than the plurality of electronic elements 14. The plurality of first electrodes 13 are electrically connected to the plurality of electronic elements 14. The plurality of connection lines 12 are arranged side by side at intervals. Each connection line 12 of the plurality of connection lines 12 includes a first line segment 121, a second line segment 122 and a third line segment 123 that are connected in sequence. The first line segment 121 is disposed on the first main surface 11a of the substrate 11, and the first line segment 121 is electrically connected to one of the plurality of first electrodes 13. The second line segment 122 is disposed on the selected side surface 11cc. The third line segment 123 is disposed on the second main surface 11b of the substrate 11.

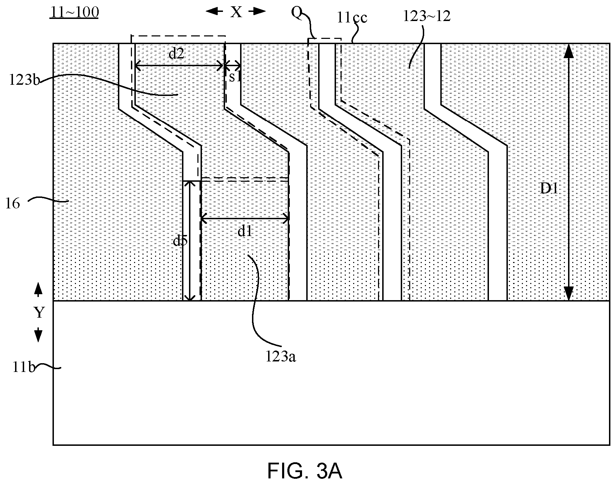

The first main surface 11a of the substrate is a front surface of the display panel 100, i.e., a display surface, and the second main surface 11b is a back surface of the display panel 100. The first line segment 121 and the third line segment 123 of the connection line 12 both extend along a direction perpendicular to the selected side surface 11cc of the substrate 11, e.g., a second direction Y shown in FIG. 2. For example, a dimension D1 of the third line segment 123 along the second direction Y is greater than a dimension D2 of the first line segment 121 along the second direction Y. The first line segment 121 is located in the peripheral area BB of the first main surface 11a, and an orthographic projection of the third line segment 123 on the first main surface 11a of the substrate 11 extends to the display area AA. Referring to FIG. 3A, the third line segment 123 includes a bonding portion 123a and a non-bonding portion 123b. The bonding portion 123a is farther away from the selected side surface 11cc relative to the non-bonding portion 123b. Bonding portions 123a of a plurality of third line segments 123 are used for bonding a circuit board. Specifically, the bonding portions 123a of the plurality of third line segments 123 are coupled to bonding electrodes of the circuit board. It will be noted that in the embodiments of the present disclosure, at least 80% of a region of the bonding portion 123a of the third line segment 123 is coupled to a bonding electrode of the circuit board, and no more than 15% of a region of the non-bonding portion 123b of the third line segment 123 may be coupled to the bonding electrode of the circuit board.

It will be noted that the plurality of first electrodes and the plurality of electronic elements 14 may be in indirect contact with the first main surface 11a of the substrate 11. For example, an insulating layer is provided between the plurality of first electrodes 13 and the first main surface 11a of the substrate 11, a film layer structure such as a driving circuit layer is provided between the plurality of electronic elements 14 and the first main surface 11a of the substrate 11, and the driving circuit layer includes signal lines. The plurality of first electrodes 13 are electrically connected to the electronic elements 14 through the signal lines in the driving circuit layer. The signal lines are configured to transmit signals to the electronic element 14s to drive the electronic elements 14 to emit light. Each first electrode 13 of the plurality of first electrodes 13 is electrically connected to (e.g., in contact with) a first line segment 121 of a connection line 12.

For example, shapes of the first main surface 11a and the second main surface 11b of the substrate 11 each are, for example, a rectangle, and a material of the substrate 11 is, for example, a rigid material such as glass or quartz.

For example, as shown in FIG. 1, the display panel 100 includes sub-pixels P of at least three colors, and the sub-pixels of these colors include at least sub-pixels of a first color, sub-pixels of a second color, and sub-pixels of a third color. The first color, the second color and the third color are three primary colors (such as red, green and blue). For example, each sub-pixel P includes at least one light-emitting device, which is an electronic element 14.

For example, the electronic element 14 may be, but is not limited to, an organic light-emitting diode (OLED), a Mini LED, a Micro LED, or the like.

In some embodiments, as shown in FIG. 3A, the plurality of third line segments 123 are arranged at intervals along the first direction X. The plurality of third line segments 123 are composed of a metal coating. A distance between two adjacent third line segments 123 is constant. Of the third line segment, a dimension of the bonding portion 123a in the second direction Y is equal to a dimension of the non-bonding portion 123b in the second direction Y; and a bonding portion 123a of any one third line segment 123 extends along the second direction Y.

In the display panel 100 shown in FIG. 3A, a surface of the bonding portion 123a of the third line segment 123 has a relatively large area, that is, has a relatively large contact area with the second main surface 11b of the substrate 11. If there exist foreign matters between the third line segment 123 and the second main surface 11b, there will appear a phenomenon where a bonding portion 123a of a third line segment 123 is affected and falls off during the process of removing the circuit board bonded and connected to the bonding portion 123a or cleaning a surface circuit board of the bonding portion 123a to be connected to the circuit board, causing a connection line 12 to be disconnected, thereby affecting signal transmission, causing certain damage to the display panel 100, and affecting the quality of the product.

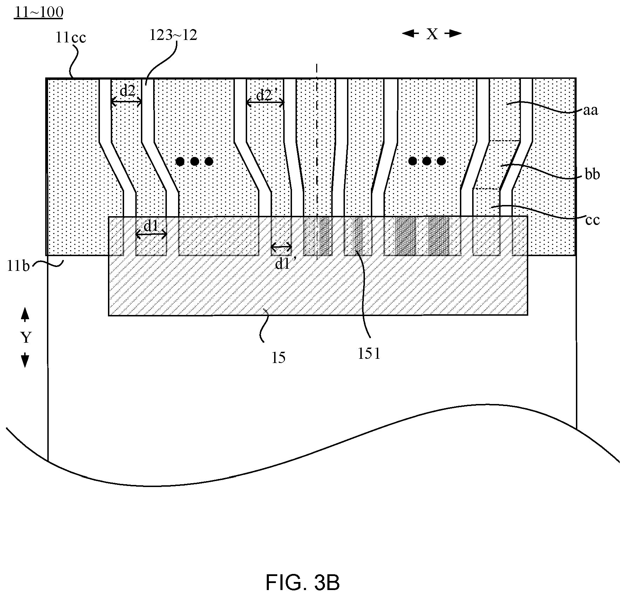

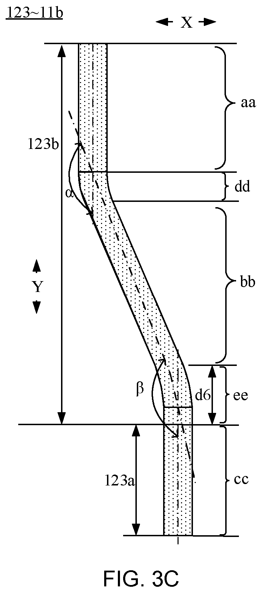

In some embodiments, as shown in FIGS. 3B and 3C, the third line segment 123 includes a first sub-line segment aa, a second sub-line segment bb, and a third sub-line segment cc that are connected in sequence. The first sub-line segment aa is proximate to the selected side surface 11cc. First sub-line segments aa of the plurality of connection lines 12 are arranged at intervals along the first direction X, and third sub-line segments cc of the plurality of connection lines 12 are arranged at intervals along the first direction X. An extension direction of the first sub-line segment aa intersects an extension direction of the second sub-line segment bb, and the extension direction of the second sub-line segment bb intersects an extension direction of the third sub-line segment cc. The first sub-line segment aa and the second sub-line segment bb may be connected through a first connection portion dd, and the second sub-line segment bb and the third sub-line segment cc may be connected through a second connection portion ee. The bonding portion 123a is the three sub-line segments cc, and the non-bonding portion 123b is the first sub-line segment aa, the first connection portion dd, the second sub-line segment bb and the second connection portion ee. A boundary line of an orthographic projection of the second connection portion ee on the second main surface 11b is in a shape of a curve.

For example, as shown in FIGS. 3B and 3C, the first sub-line segment aa, the second sub-line segment bb and the third sub-line segment cc are all straight line segments. The extension direction of the first sub-line segment aa is parallel to the extension direction of the third sub-line segment cc, and both ends of the second sub-line segment bb are connected to the first sub-line segment aa and the third sub-line segment cc, respectively. An angle α formed between the extension direction of the first sub-line segment aa and the extension direction of the second sub-line segment bb satisfies: greater than 90° and less than 180° (90° < α < 180°); and an angle β formed between the extension direction of the second sub-line segment bb and the extension direction of the third sub-line segment cc satisfies: greater than 90° and less than 180° (90° < β < 180°). The first sub-line segment aa and the second sub-line segment bb are connected through the first connection portion dd, and the second sub-line segment bb and the third sub-line segment cc are connected through the second connection portion ee. The first connection portion dd, the first sub-line segment aa and the second sub-line segment bb all belong to the connection line 12. The first sub-line segment aa, the first connection portion dd and the second sub-line segment bb are connected in sequence and formed into a one-piece structure.

The bonding portion 123a is composed of the third sub-line segment cc, and the non-bonding portion 123b includes at least the first sub-line segment aa, the first connection portion dd, the second sub-line segment bb, and the second connection portion ee. The boundary line of the orthographic projection of the second connection portion ee on the second main surface 11b is in the shape of a curve. The second connection portion ee includes a straight line segment, and the straight line segment is connected to one end of the third sub-line segment cc. The second connection portion ee, the third sub-line segment cc and the second sub-line segment bb all belong to the connection line 12. The third sub-line segment cc, the second connection portion ee and the second sub-line segment bb are connected in sequence and formed into a one-piece structure.

In some embodiments, as shown in FIG. 3B, first sub-line segments aa of at least two third line segments 123 have different dimensions in the first direction X. A maximum dimension of the first sub-line segment aa of the third line segment 123 of each connection line 12 in a direction perpendicular to an extension direction of the first sub-line segment aa is positively proportional to a maximum dimension of the first line segment 121 of the connection line 12 in a direction perpendicular to an extension direction of the first line segment 121. The maximum dimension of the first line segment 121 of the connection line 12 in the direction perpendicular to the extension direction of the first line segment 121 is positively proportional to a line width of a first electrode 13 connected to the first line segment 121; and the line width of the first electrode 13 is positively proportional to a line width of a signal line connected to the first electrode 13.

For example, the driving circuit layer of the display panel includes a plurality of signal lines, each signal line is electrically connected to one of the plurality of first electrodes 13, and each of the first electrodes 13 is electrically connected to (e.g., in contact with) a first line segment 121 of a connection line 12. Since different signal lines in the driving circuit layer of the display panel are used for transmitting different signals, the signal lines for transmitting different signals have different widths. Correspondingly, a dimension of a first electrode in the first direction and a dimension of a connection line 12 in the first direction X are positively proportional to a width of a signal line electrically connected thereto, that is, a dimension of a first sub-line segment aa in the first direction X is positively proportional to the width of the signal line electrically connected to the first sub-line segment aa. Therefore, dimensions of first sub-line segments aa or dimensions of bonding portions 123a of different third line segments 123 in the first direction X are different. Referring to FIG. 3B, among the plurality of third line segments 123, a dimension of a first sub-line segment aa of one third line segment 123 in the first direction X is d2, and a dimension of a first sub-line segment aa of another third line segment 123 in the first direction X is d2', where d2 is not equal to d2'.

In some embodiments, as shown in FIG. 3B, bonding portions 123a of at least two third line segments 123 have different dimensions in the first direction X.

For example, referring to FIG. 3B, among the plurality of third line segments 123, a dimension of a bonding portion 123a of one third line segment 123 in the first direction X is d1, and a dimension of a bonding portion 123a of another third line segment 123 in the first direction X is d1', where d1 is not equal to d1'.

In some embodiments, as shown in FIG. 3B, for at least two third line segments 123, their bonding portions 123a are connected to different numbers of bonding electrodes 151.

For example, the circuit board 15 includes a plurality of bonding electrodes 151 for bonding. The plurality of bonding electrodes 151 are electrically connected to the bonding portions 123a of the plurality of third line segments 123. Since bonding portions 123a of different third line segments 123 have different dimensions in the first direction, the bonding portions of different third line segments 123 may be connected to different numbers of bonding electrodes 151. For example, a number of bonding electrodes connected to a large-sized bonding portion is greater than a number of bonding electrodes connected to a small-sized bonding portion. Referring to FIG. 3B, among the plurality of third line segments 123, a bonding portion 123a of one third line segment 123 is connected to one bonding electrode 151, and a bonding portion 123a of another third line segment 123 is connected to two bonding electrodes 151.

In some embodiments, a distance between two adjacent bonding portions 123a takes a value in a range of 20 µm to 60 µm, inclusive.

For example, referring to FIG. 3A, the plurality of connection lines 12 are arranged at intervals. In the process of manufacturing the third line segments 123 of the connection lines 12, a metal coating, which is formed as a film in a single process, can be removed in some regions by laser etching process to form spacing regions Q. That is, there is a spacing region Q between adjacent third line segments 123 to separate the adjacent third line segments 123. Further, any two adjacent spacing regions Q are provided with a third line segment 123 therebetween. That is to say, the plurality of third line segments 123 are arranged at intervals along the first direction X. There is a spacing region Q between a third line segment 123 closest to a side surface, perpendicular to the selected side surface 11cc, of the substrate 11 and the side surface, perpendicular to the selected side surface 11cc, of the substrate 11, so that any one third line segment 123 is separated from other electrical patterns surrounding thereto (including other third line segments 123). The distance s between two adjacent bonding portions 123a is a dimension of the spacing region Q between two adjacent bonding portions 123a, where s1 may be 20 µm, 30 µm, 40 µm, 50 µm, or 60 µm.

In some embodiments, a dimension d6 of the second connection portion ee in the second direction Y is in a range of 0.1 mm to 0.3 mm, inclusive.

For example, referring to FIG. 3C, the second connection portion ee is not used as the bonding portion 123a because the boundary line of the orthographic projection of the second connection portion ee on the second main surface 11b is in the shape of a curve, which makes the second connection portion ee difficult to achieve a complete fit with the bonding electrode of a straight segment. The second connection portion ee is in the non-bonding portion 123b, and as a bridge portion connecting the second sub-line segment bb and the third sub-line segment cc, a dimension of the second connection portion ee in the second direction Y may be 0.1 mm, 0.15 mm, 0.2 mm, 0.25 mm or 0.3 mm.

In some embodiments, a dimension of the third line segment 123 in the second direction Y is in a range of 1.5 mm to 5 mm, inclusive.

For example, referring to FIG. 3A, the dimension D1 of the third line segment 123 in the second direction Y may be 1.5 mm, 2.0 mm, 2.5 mm, 3 mm, 3.5 mm, 4.0 mm, 4.5 mm or 5 mm.

In some embodiments, the dimension of the first sub-line segment aa in the first direction X is greater than or equal to the dimension of the third sub-line segment cc in the first direction X.

For example, referring to FIG. 3A, the dimension of the first sub-line segment aa in the first direction X is d2, and the dimension of the third sub-line segment cc in the first direction X is d1, where d2 is greater than or equal to d1 (d2 ≥ d1).

It will be noted that a dimension of the first sub-line segment aa along the first direction X is equal to a dimension of the non-bonding portion 123b of the third line segment 123 along the first direction X, both are d2.

In some embodiments, as shown in FIG. 3A, a ratio of a dimension of the bonding portion 123a of the third line segment 123 in the second direction Y to a dimension of the third line segment 123 in the second direction Y is in a range of 0.4 to 0.5, inclusive.

For example, referring to FIG. 3A, the dimension of the bonding portion 123a of the third line segment 123 along the second direction Y is d5, and the dimension of the third line segment 123 along the second direction Y is D1. The ratio of the two may be 0.4, 0.45 or 0.5. For example, d5 is equal to 0.65 mm, D1 is equal to 1.5 mm, and the ratio between the two is within the range of 0.4 to 0.5. The range of the ratio of the two is determined based on the position at which the third line segment 123 is bonded to the circuit board, and the transmission capability of the connection line 12.

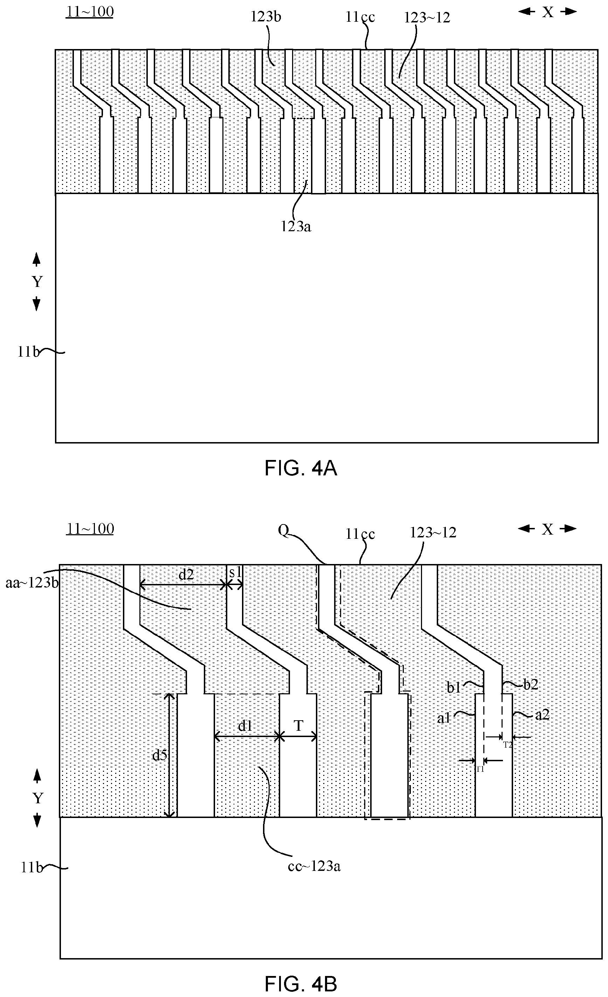

In light of this, in some embodiments of the present disclosure, as shown in FIGS. 4A to 6B, an area of an orthographic projection of a bonding portion 123a of a third line segment 123 on the second main surface 11b is less than a theoretical area value, where the theoretical area value is the product of the dimension d5 of the bonding portion 123a along the second direction Y and the dimension d2 of the non-bonding portion 123b along the first direction X as shown in FIG. 3A. The dimension d1 of the bonding portion 123a along the first direction X is equal to the dimension d2 of the non-bonding portion 123b along the first direction X. That is to say, the theoretical area value can be understood as a value of an area of the projection of the bonding portion 123a in FIG. 3A. A pattern of the bonding portion 123a of the third line segment 123 in the related art as shown in FIG. 3A, and the embodiments of the present disclosure have made improvements to the bonding portion 123a in the related art. As shown in FIGS. 4A to 6B, the area of the orthographic projection of the improved bonding portion 123a (shown in FIGS. 4A to 6B) on the second main surface 11b is less than the area of the orthographic projection of the bonding portion 123a (shown in FIG. 3A) on the second main surface 11b in the related art.

For example, referring to FIGS. 4A to 6B, the area of the orthographic projection of the bonding portion 123a of the third line segment 123 on the second main surface 11b is less than the area of the bonding portion 123a of the third line segment 123 in FIG. 3A. That is to say, a contact area between the bonding portion 123a of the third line segment 123 and the second main surface 11b reduces accordingly, reducing the probability of foreign matters and other impurities existing between the bonding portion 123a of the third line segment 123 and the second main surface 11b, which can effectively reduce the probability of an open circuit caused by falling off of the bonding portion 123a during the process of removing and re-bonding the circuit board, thereby improving the quality and yield of the product.

In some embodiments, as shown in FIGS. 4A and 4B, a dimension of the bonding portion 123a of the third line segment 123 along the first direction X is less than a dimension of the non-bonding portion 123b along the first direction X. The first direction X is a direction in which the plurality of third line segments 123 are arranged. In these embodiments, by reducing the dimension of the bonding portion 123a along the first direction X, i.e., increasing a dimension of an etching channel (i.e., the spacing region Q) between adjacent bonding portions 123a, the area of the bonding portions 123a can be reduced. These embodiments will hereinafter be referred to as Scheme 1 briefly.

For example, referring to FIGS. 4A and 4B, the dimension of the bonding portion 123a of the third line segment 123 along the first direction X is d1, and the dimension of the non-bonding portion 123b of the third line segment 123 along the first direction X is d2, where d1 is less than d2 (d1 < d2). That is to say, while manufacturing the connection lines 12 of the display panel 100, a size of the bonding portion 123a is limited, so that the bonding portion 123a has a relatively small contact area with the second main surface 11b. In this way, it is possible to reduce the risk of the bonding portion 123a of the third line segment 123 being affected and falling off during the subsequent process of removing and re-bonding the circuit board, and to improve the yield of the display panel 100.

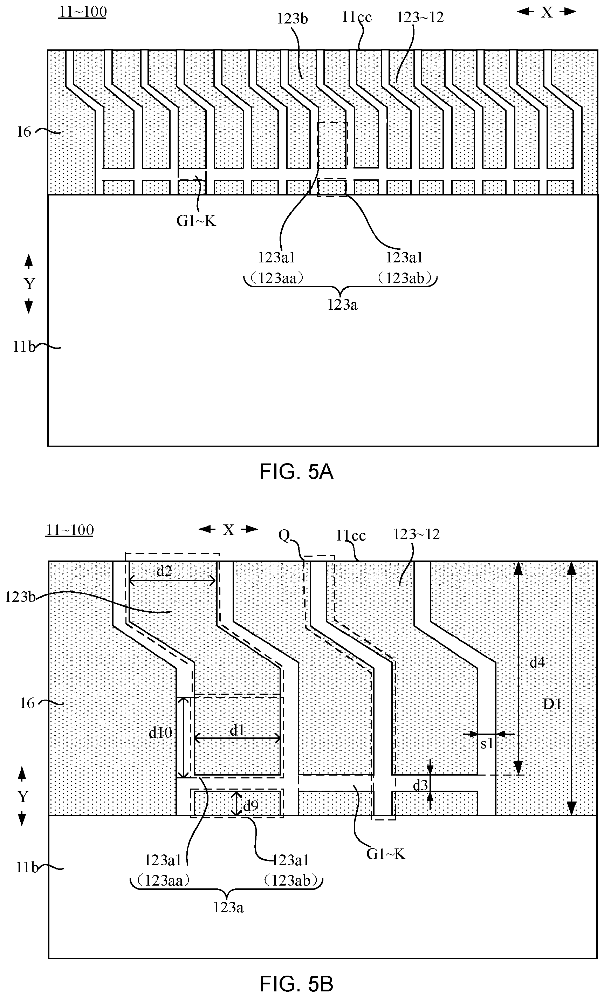

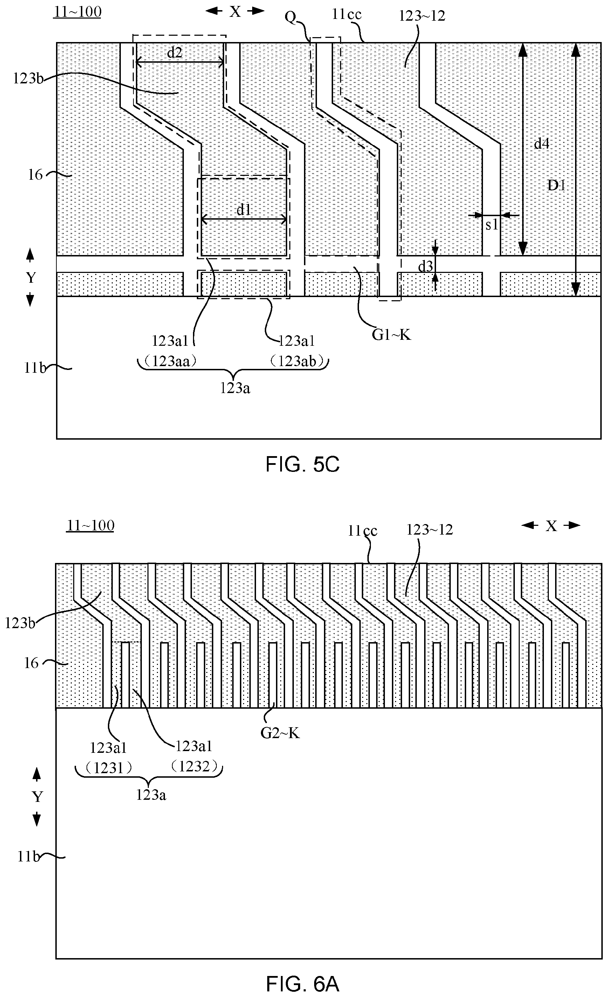

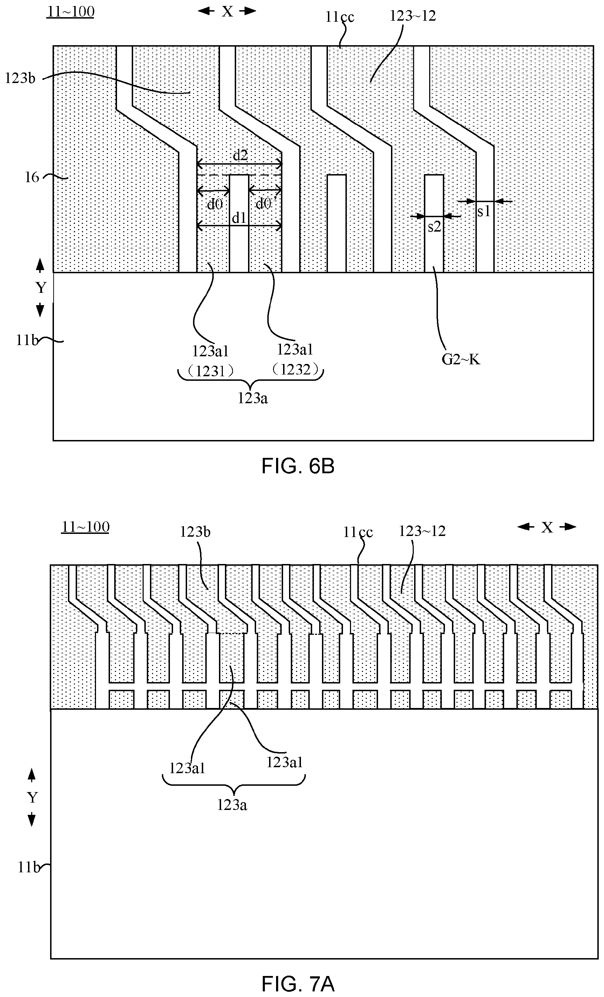

In some embodiments, referring to FIGS. 5A, 5B, 5C, 6A and 6B, among the plurality of third line segments 123, a bonding portion 123a of at least one third line segment 123 includes two sub-bonding portions 123a1, and at least one sub-bonding portion 123a1 of the two sub-bonding portions 123a1 is connected to a non-bonding portion 123b of the third line segment 123. In these embodiments, on the basis of the bonding portion 123a shown in FIG. 3A, a hollowed-out region K is provided in the bonding portion 123a, and the metal coating 16 in the hollowed-out region K is removed, so that the bonding portion 123a is divided into the two sub-bonding portions 123a1, realizing a reduction in the area of the bonding portion 123a. These embodiments will hereinafter be referred to as Scheme 2 briefly.

As a possible design, as shown in FIGS. 5A, 5B, 5C, 6A and 6B, the dimension d1 of the bonding portion 123a of the third line segment 123 along the first direction X is equal to the dimension d2 of the non-bonding portion 123b along the first direction X. That is to say, two opposite side edges of two adjacent third line segments 123 have a constant spacing in a direction perpendicular to their extension directions.

For example, as shown in FIGS. 5B and 5C, the bonding portion 123a of each third line segment 123 of the plurality of third line segments 123 includes two sub-bonding portions 123a1, in which one sub-bonding portion 123a1 is proximate to the selected side surface 11cc and is connected to the non-bonding portion 123b of the third line segment 123; and the other sub-bonding portion 123a1 is disposed on a side of the third line segment 123 away from the selected side surface 11cc. Areas of orthographic projections of the two sub-bonding portions 123a1 on the second main surface 11b are not equal.

For example, as shown in FIGS. 6A and 6B, the bonding portion 123a of each third line segment 123 of the plurality of third line segments 123 includes two sub-bonding portions 123a1. Orthographic projections of the two sub-bonding portions 123a1 on the second main surface 11b of the substrate 11 have the same area, and the two sub-bonding portions 123a1 have the same distance from the selected side surface 11c. The two sub-bonding portions 123a1 are both connected to the non-bonding portion 123b of the third line segment 123.

The above-mentioned arrangement of the bonding portion 123a into two sub-bonding portions 123a1, in one aspect, which can ensure that the bonding portion 123a has a relatively small contact area with the second main surface 11b during the subsequent process of removing and re-bonding the circuit board, further reducing the risk of the bonding portion 123a of the third line segment 123 being affected and falling off during the removal of the circuit board, and improving the yield of the display panel 100; in another aspect, since the bonding portion 123a is divided into the two sub-bonding portions 123a1, and at least one of the two sub-bonding portions 123a1 is connected to the non-bonding portion 123b of the third line segment 123, and the two sub-bonding portions 123a1 are separated by a hollowed-out region K, in this way, the two sub-bonding portions 123a1 of the bonding portion 123a are both connected to the circuit board. When the circuit board is removed, if one of the sub-bonding portions 123a1 is affected and falls off along with the removal of the circuit board, the other sub-bonding portion 123a1 will still be retained on the second main surface 11b of the substrate 11 to prevent the entire bonding portion 123a from being affected and falling off, so that even if one of the sub-bonding portions 123a1 falls off, the remaining sub-bonding portion(s) 123a1 are still attached to the second main surface 11b and connected to the non-bonding portion 123b of the third line segment 123 realize the function of transmitting electrical signals, thereby preventing the third line segment 123 from being disconnected and affecting the quality of the display panel.

In some embodiments, as shown in FIGS. 7A to 7D, a dimension of the bonding portion 123a of the third line segment 123 along the first direction X is less than a dimension of the non-bonding portion 123b along the first direction X, where the first direction X is a direction in which the plurality of third line segments 123 are arranged. Among the plurality of third line segments 123, a bonding portion 123a of at least one third line segment 123 includes two sub-bonding portions 123a1, and at least one sub-bonding portion 123a1 of the two sub-bonding portions 123a1 is connected to the non-bonding portion 123b of the third line segment 123. These embodiments are a combination of Scheme 1 and Scheme 2.

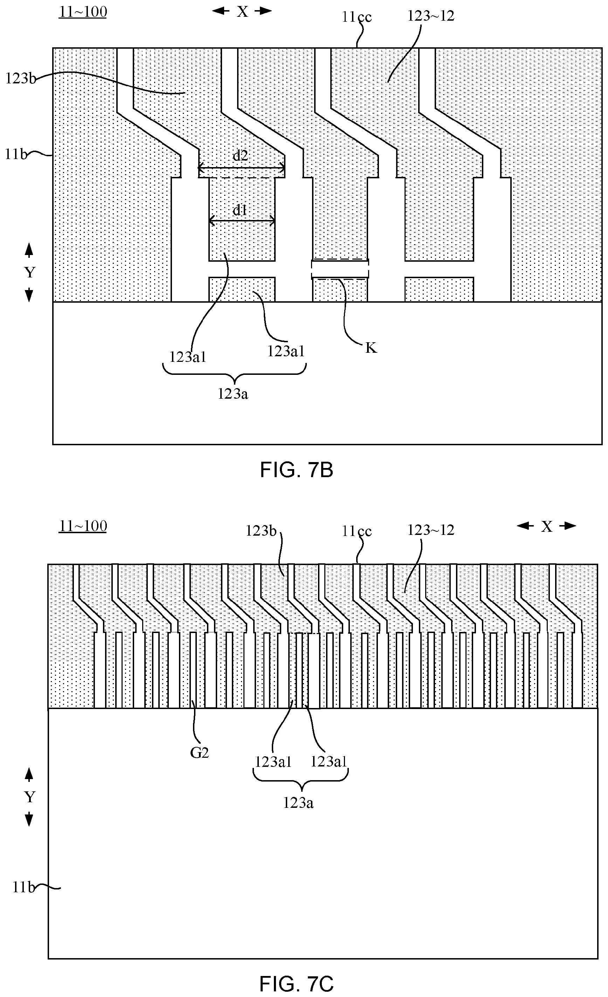

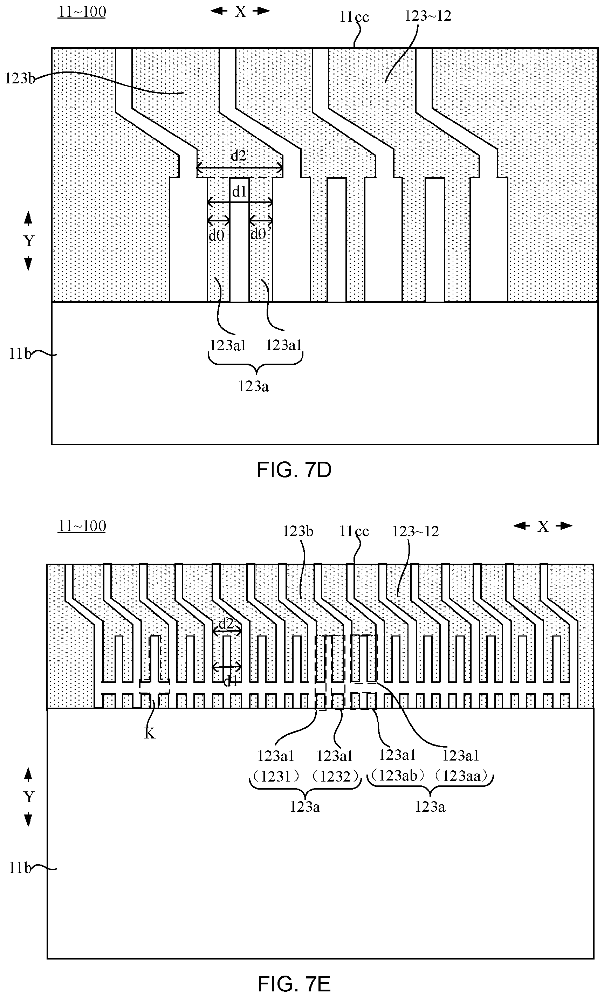

For example, as shown in FIGS. 7A and 7B, the dimension of the bonding portion 123a of the third line segment 123 along the first direction X is d1, and the dimension of the non-bonding portion 123b of the third line segment 123 along the first direction X is d2, where d1 is less than d2 (d1 < d2). Referring to FIGS. 7A and 7B, one of two sub-bonding portions 123a1 included in the bonding portion 123a of each third line segment 123 of the plurality of third line segments 123 is proximate to the selected side surface 11cc and is connected to the non-bonding portion 123b of the third line segment 123, and the other sub-bonding portion 123a1 is disposed on a side of the third line segment 123 away from the selected side surface 11cc. Orthographic projections of the two sub-bonding portions 123a1 on the second main surface 11b have different areas. Referring to FIGS. 7C and 7D, the dimension of the bonding portion 123a of the third line segment 123 along the first direction X is d1, and the dimension of the non-bonding portion 123b of the third line segment 123 along the first direction X is d2, where d1 is less than d2 (d1 < d2). Orthographic projection of the two sub-bonding portions 123a1 of each third line segment 123 of the plurality of third line segments 123 on the second main surface 11b of the substrate 11 have the same area, the two sub-bonding portions 123a1 have the same distance from the selected side surface 11c, and the two sub-bonding portions 123a1 are both connected to the non-bonding portion 123b of the third line segment 123.

By combining Scheme 1 and Scheme 2, while manufacturing the connection lines of the display panel, a size of the bonding portion 123a is limited, and the bonding portion 123a is set into two sub-bonding portions 123a1, in this way, during the process of removing and re-bonding the circuit board, in one aspect, which can be ensured that the bonding portion 123a has a relatively small contact area with the second main surface 11b, and the presence of foreign matters between the bonding portion 123a and the second main surface 11b is relatively reduced; in another aspect, a hollowed-out region K is provided between the two sub-bonding portions 123a1, and the two sub-bonding portions 123a1 are separated by the hollowed-out region K. By sacrificing one of the sub-bonding portions 123a1 when removing the circuit board, the sacrificed sub-bonding portion will fall off, the remaining sub-bonding portion(s) are retained on the substrate to serve as circuit connections, further reducing the risk of the entire bonding portion 123a of the third line segment 123 being affected and falling off during the process of removing the circuit board, thereby improving the yield of the display panel 100.

As shown in FIGS. 4Aand 4B, Scheme 1 is specifically illustrated. In this Scheme, the dimension d1 of the bonding portion 123a along the first direction X is less than the dimension d2 of the non-bonding portion 123b along the first direction X.

In some embodiments, of the third line segment 123, a difference between the maximum dimension d1 of the bonding portion 123a along a direction perpendicular to an extension direction of the bonding portion 123a and the maximum dimension d2 of the non-bonding portion 123b along a direction perpendicular to an extension direction of the non-bonding portion 123b is in a range of 20 µm to 50 µm, inclusive.

For example, referring to FIGS. 4A and 4B, it can be seen from the figures that a distance between two opposite side edges of the bonding portion 123a parallel to the extension direction thereof is reduced a certain extent relative to the non-bonding portion 123b, and the difference between the dimension d1 and the dimension d2 is in the range of 20 µm to 50 µm, such as 20 µm, 30 µm, 40 µm or 50 µm. If the difference between the maximum dimension d1 of the bonding portion 123a along the direction perpendicular to the extension direction thereof and the maximum dimension d2 of the non-bonding portion 123b along the direction perpendicular to the extension direction thereof is 20 µm, the distance between the two opposite side edges of the bonding portion 123a parallel to the extension direction thereof is reduced by 10 µm relative to the non-bonding portion 123b. If the difference between the maximum dimension d1 of the bonding portion 123a along the direction perpendicular to the extension direction thereof and the maximum dimension d2 of the non-bonding portion 123b along the direction perpendicular to the extension direction thereof is 30 µm, the distance between the two opposite side edges of the bonding portion 123a parallel to the extension direction thereof is reduced by 15 µm relative to the non-bonding portion 123b. If the difference between the maximum dimension d1 of the bonding portion 123a along the direction perpendicular to the extension direction thereof and the maximum dimension d2 of the non-bonding portion 123b along the direction perpendicular to the extension direction thereof is 40 µm, the distance between the two opposite side edges of the bonding portion 123a parallel to the extension direction thereof is reduced by 20 µm relative to the non-bonding portion 123b. If the difference between the maximum dimension d1 of the bonding portion 123a along the direction perpendicular to the extension direction thereof and the maximum dimension d2 of the non-bonding portion 123b along the direction perpendicular to the extension direction thereof is 50 µm, the distance between the two opposite side edges of the bonding portion 123a parallel to the extension direction thereof is reduced by 25 µm relative to the non-bonding portion 123b.

It can be understood that in some embodiments, the non-bonding portion 123b does not necessarily extend in a specific direction, for example, the non-bonding portion 123b has a polyline shape; and in some embodiments, a line width of the non-bonding portion 123b at different positions is not exactly the same.

In some embodiments, the bonding portion 123a extends along the second direction and has the same dimension at all positions, and the dimension of the bonding portion 123a in the first direction X is greater than or equal to 80 µm.

For example, continuing to refer to FIGS. 4A and 4B, the dimension of the bonding portion 123a along the first direction X is d1, and d1 may be 80 µm, 90 µm, 100 µm, 110 µm, 120 µm, or the like. Setting the bonding portion 123a in the first direction X with the dimension d1 as above is considered, in an aspect, that the resistance of the third line segment 123 should not be too large to be able to ensure efficient signal transmission, and in another aspect, it is necessary to ensure effective contact between the bonding electrode of the circuit board and the bonding portion 123a of the third line segment 123, which is favorable for the bonding of the circuit board.

In some embodiments, a distance T between bonding portions 123a of two adjacent third line segments 123 is in a range of 40 µm to 110 µm, inclusive.

Correspondingly, the distance between two adjacent non-bonding portions 123b is s1, and the distance T between the bonding portions 123a of the two adjacent third line segments is greater than or equal to the distance s1 between the two adjacent non-bonding portions 123b, that is, T ≥ s1.

For example, continuing to refer to FIGS. 4A and 4B, the plurality of connection lines 12 are formed by etching the continuous metal coating 16, with a spacing region Q between adjacent third line segments 123. The metal coating 16 in the spacing region Q is removed by a laser etching process to separate the adjacent third line segments 123. Furthermore, one third line segment 123 is provided between any two adjacent spacing regions Q, that is to say, the plurality of third line segments 123 are arranged at intervals along the first direction X. There is a spacing region Q between a third line segment 123 closest to a side surface, perpendicular to the selected side surface 11cc, of the substrate 11 and the side surface, perpendicular to the selected side surface 11cc, of the substrate 11, so that any one third line segment 123 is separated from other electrical patterns surrounding thereto (including other third line segments 123). The distance T between two adjacent bonding portions 123a is a dimension of a spacing region Q between the two adjacent bonding portions 123a, where T may be 40 µm, 50 µm, 60 µm, 70 µm, 80 µm, 90 µm, 100 µm, 110 µm, or the like.

In some embodiments, two opposite side edges of a portion of the non-bonding portion 123b connected to the bonding portion 123a in the first direction X is a first side edge b1 and a second side edge b2, and two opposite side edges of the bonding portion 123a in the first direction X is a third side edge a1 and a fourth side edge a2, in which the first side edge b1 and the third side edge a1 are located at a same side, and the second side edge b2 and the fourth side edge a2 are located at a same side. A distance between the first side edge b1 and the third side edge a1 is equal to a distance between the second side edge b2 and the fourth side edge a2.

For example, continuing to refer to FIGS. 4A and 4B, a distance between the first side edge b1 and the second side edge b2 of the non-bonding portion 123b is greater than a distance between the third side edge a1 and the fourth side edge a2 of the bonding portion 123a. And the distance between the first side edge b1 and the third side edge a1 is T1, and the distance between the second side edge b2 and the fourth side edge a2 is T2, where T1 = T2. That is to say, compared with the non-bonding portion 123b, dimensions of both ends of the bonding portion 123a are evenly narrower, and the contact area between the bonding portion 123a and the circuit board can be reduced, further reducing the risk of the bonding portion 123a of the third line segment 123 from falling off.

As shown in FIGS. 5A to 5C, the first implementation of Scheme 2 is introduced in detail. In this implementation, the bonding portion is divided into two sub-bonding portions 123a1 through a first isolation region G1.

In some embodiments, as shown in FIGS. 5A to 5C, the bonding portion 123a of the third line segment 123 includes a first sub-bonding portion 123aa and a second sub-bonding portion 123ab arranged along the second direction Y, where the first sub-bonding portion 123aa is connected to the non-bonding portion 123b, and the first isolation region G1 is provided between the first sub-bonding portion 123aa and the second sub-bonding portion 123ab; and an area of the first sub-bonding portion 123aa is greater than an area of the second sub-bonding portion 123ab.

It will be noted that the first isolation region G1 is a region between the first sub-bonding portion 123aa and the second sub-bonding portion 123ab on the second main surface 11b. There is no metal coating in the first isolation region G1. The second main surface 11b is exposed in the first isolation region G1.

For example, as shown in FIG. 5B, the first isolation region G1 is provided between the first sub-binding part 123aa and the second sub-binding part 123ab, so that the first sub-binding part 123aa and the second sub-binding part 123ab are separated.

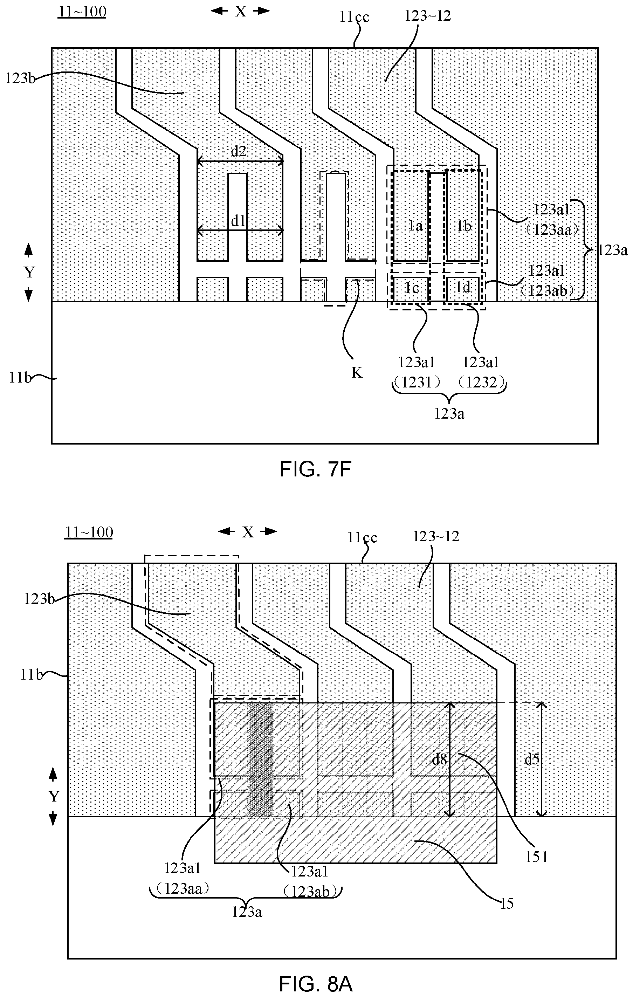

As shown in FIG. 8A, for example, the bonding electrode 151 is electrically connected to the bonding portion 123a. A dimension d8 of the bonding electrode 151 in the circuit board 15 in the second direction Y is greater than or equal to the sum (e.g., d5) of dimensions of the first sub-bonding portion 123aa, the second sub-bonding portion 123ab and the first isolation region G1 in the second direction Y, and the bonding electrode 151 is electrically connected to both the first sub-bonding portion 123aa and the second sub-bonding portion 123ab. In this case, the bonding electrode 151 serves as a bridge part to realize an electrical connection between the first sub-bonding portion 123aa and the second sub-bonding portion 123ab. It will be noted that since the second sub-bonding portion 123ab is separated from the first sub-bonding portion 123aa, there is no direct contact between them. Before the circuit board is bonded, that is, there is no connection between the second sub-bonding portion 123ab and structures on the first main surface of the substrate, even if the bonding electrode 151 of the circuit board 15 overlaps with the second sub-bonding portion 123ab, the second sub-bonding portion 123ab does not have the function of transmitting electrical signals to the electronic elements on the first main surface.

During the manufacturing process of the display panel 100, especially during the process of removing and re-bonding the circuit board, there is a risk that the bonding portion 123a is easily affected and falls off, thereby affecting the manufacturing process and the quality of the display panel 100 finally obtained. The first isolation region G1 is provided between the first sub-bonding portion 123aa and the second sub-bonding portion 123ab. In an aspect, the bonding portion 123a can have a small contact area with the second main surface 11b, and damage to the product by falling off of the bonding portion 123a during the manufacturing process may be reduced. In another aspect, during the process of removing the circuit board, the removal process may be performed in a direction from the sub-bonding portion 123a1 toward the selected side surface 11c, first, a portion, attached to a surface of the sub-bonding portion 123a1 (the second sub-bonding portion 123ab) on a side of the third line segment 123 away from the selected side surface 11cc, of the circuit board is removed; since the area of the orthographic projection of the first sub-bonding portion 123aa on the second main surface 11b is greater than the area of the orthographic projection of the second sub-bonding portion 123ab on the second main surface 11b, the second sub-bonding portion 123ab is easier to be removed than the first sub-bonding portion 123aa; in the second direction Y, the first isolation region G1 is provided between the first sub-bonding portion 123aa and the second sub-bonding portion 123ab, which can separate the first sub-bonding portion 123aa from the second sub-bonding portion 123ab; and in a case where the second sub-bonding portion 123ab falls off, the first isolation region G1 has a certain protective effect on the first sub-bonding portion 123aa, which can reduce the risk of the first sub-bonding portion 123aa falling off during the process of removing the circuit board, thereby improving the yield of the display panel 100. Since the second sub-bonding portion 123ab has no function of transmitting electrical signals, even if the second sub-bonding portion 123ab falls off, the circuit board 15 can still transmit electrical signals to the electronic elements through the first sub-bonding portion 123aa without affecting the normal operation of the display panel.

For example, as shown in FIG. 5C, the first isolation region G1 extends along the first direction X, separating the first sub-bonding portion 123aa from the second sub-bonding portion 123ab of at least one bonding portion 123a. A dimension of the first isolation region G1 in the first direction X may be equal to a dimension of the second main surface 11b in the first direction X, so that first sub-bonding portions 123aa of all bonding portions 123a can be separated from second sub-bonding portions 123ab of all bonding portions 123a. The first isolation region G1 enables no direct contact between the first sub-bonding portion 123aa and the second sub-bonding portion 123ab, and reduces the contact area between the bonding portion 123a and the second main surface 11b. Thus, the process of manufacturing the display panel 100 has beneficial effects as described in the above-described embodiments, which are not described herein.

In some embodiments, the bonding portions 123a of the plurality of third line segments 123 each include a first sub-bonding portion 123aa and a second sub-bonding portion 123ab, and a first isolation region G1 corresponding to each bonding portion 123a extends along the first direction X. Dimensions of a plurality of first isolation regions G1 in the second direction Y are equal, and the plurality of first isolation regions G1 have the same distance from the selected side surface 11cc, where the second direction Y is perpendicular to the first direction X.

For example, referring to FIGS. 5B and 5C, dimensions of the plurality of first isolation regions G1 in the second direction Y each are d3 and are all equal, and the plurality of first isolation regions G1 have the same distance d4 with the selected side surface 11cc.

That is to say, ends of first sub-bonding portions 123aa of the plurality of bonding portions 123a away from the selected side surface 11cc are flush, so the plurality of bonding portions 123a are relatively regular in structure, facilitating to bond the circuit board.

In some embodiments, the dimension d3 of the first isolation region G1 in the second direction Y is in a range of 15 µm to 30 µm, inclusive.

For example, referring to FIGS. 5B and 5C, the dimension d3 of the first isolation region G1 in the second direction Y may be 15 µm, 20 µm, 25 µm, or 30 µm. The dimension d3 of the first isolation region G1 in the second direction Y is set within the suitable range, in an aspect, the first isolation region G1 is prevented from being too wide to require multiple etchings, which can improve production efficiency and prevent multiple laser etchings from causing damage to the display panel; in another aspect, the first isolation region G1 can be prevented from being too narrow to effectively separate the first sub-bonding portion 123aa from the second sub-bonding portion 123ab.

In some embodiments, as shown in FIG. 5B, a ratio of a dimension d9 of the second sub-bonding portion 123ab in the second direction Y to a dimension d10 of the first sub-bonding portion 123aa in the second direction Y is a range of 0.08 to 0.1, inclusive, where the second direction Y is perpendicular to the first direction X.

For example, the ratio of the dimension d9 of the second sub-bonding portion 123ab in the second direction Y to the dimension d10 of the first sub-bonding portion 123aa in the second direction Y may be 0.08, 0.09 or 0.1. For example, the dimension d9 of the second sub-bonding portion 123ab in the second direction Y is 0.6 mm, and the dimension d10 of the first sub-bonding portion 123aa in the second direction Y is 0.75 mm, so the ratio of the two is 0.08. The ratio of the two is set within a certain range based on bonding the circuit board to the third line segment 123 of the connection line 12. Moreover, the ratio of the dimensions of the two sub-bonding portions is within this range, so that damage to the product caused by the falling off of the bonding portion 123a during the manufacturing process may be relatively well avoided.

In some embodiments, the dimension of the first sub-bonding portion 123aa in the second direction Y is in a range of 0.6 mm to 1.1 mm, inclusive; and the dimension of the second sub-bonding portion 123ab in the second direction Y is in a range of 0.05 mm to 0.2 mm, inclusive.

For example, as shown in FIGS. 5B and 5C, the first sub-bonding portion 123aa is a portion of the bonding portion 123a for bonding the circuit board, and the dimension of the first sub-bonding portion 123aa in the second direction Y may be 0.6 mm, 0.7 mm, 0.8 mm, 0.9 mm, 1.0 mm, or 1.1 mm. The dimension of the second sub-bonding portion 123ab in the second direction Y may be 0.05 mm, 0.08 mm, 0.1 mm, 0.12 mm, 0.15 mm, or 0.2 mm.

In some embodiments, as shown in FIGS. 8A to 8C, the circuit board 15 includes a plurality of bonding electrodes 151 arranged at intervals along the first direction, and each bonding portion 123a is connected to at least one bonding electrode 151. A dimension of the bonding portion 123a in the first direction X is greater than or equal to 150 µm. For example, the bonding portion 123a is connected to two adjacent bonding electrodes 151 of the circuit board 15.

For example, as shown in FIG. 8A, each bonding portion 123a includes a first sub-bonding portion 123aa and a second sub-bonding portion 123ab, and the first sub-bonding portion 123aa and the second sub-bonding portion 123ab of the bonding portion 123a are connected to a bonding electrode 151.

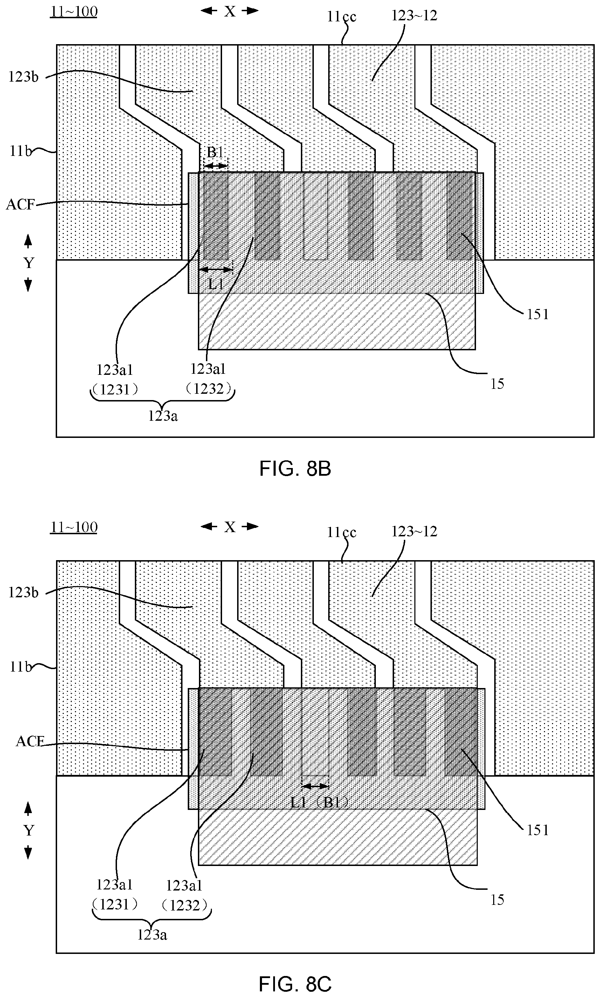

For example, as shown in FIG. 8B, the bonding portion 123a includes two adjacent sub-bonding portions 123a1, orthographic projections of the two sub-bonding portions 123a1 on the second main surface 11b of the substrate 11 have the same area, the two sub-bonding portions 123a1 have the same distance from the selected side surface 11c, and the two sub-bonding portions 123a1 are both connected to the non-bonding portion 123b of the third line segment 123. In this case, the dimension of the bonding portion 123a in the first direction X is greater than or equal to 150 µm. Each sub-bonding portion 123a1 is connected to a bonding electrode 151, and the two sub-bonding portions 123a1 are capable of cooperating with each other. In a case where one sub-bonding portion 123a1 has poor transmission, the other sub-bonding portion 123a1 can serve as a backup to achieve good signal transmission and keep the signal transmission efficiency of the display panel 100. Moreover, it may be possible to avoid damage to the product caused by one bonding portion 123a falling off during the manufacturing process.

As shown in FIGS. 6A and 6B, the second implementation of Scheme 2 is introduced in detail. In this implementation, the bonding portion 123a is divided into two sub-bonding portions 123a1 through a second isolation region G2.

In some embodiments, referring to FIGS. 6A and 6B, the bonding portion 123a of the third line segment 123 includes a third sub-bonding portion 1231 and a fourth sub-bonding portion 1232 arranged along the first direction X. The second isolation region G2 is disposed between the third sub-bonding portion 1231 and the fourth sub-bonding portion 1232. The third sub-bonding portion 1231 and the fourth sub-bonding portion 1232 are both connected to the non-bonding portion 123b; and the third sub-bonding portion 1231 and the fourth sub-bonding portion 1232 are connected to two bonding electrodes 151 respectively.

It will be noted that the second isolation region G2 is a region between the third sub-bonding portion 1231 and the fourth sub-bonding portion 1232 on the second main surface 11b. There is no metal coating in the second isolation region G2. The second main surface 11b is exposed in the second isolation region G2.

For example, the second isolation region G2 can separate the third sub-bonding portion 1231 from the fourth sub-bonding portion 1232. In an aspect, the bonding portion 123a can have a relatively small contact area with the second main surface 11b of the display panel 100, thereby reducing the risk of the bonding portion 123a of the third line segment 123 falling off during the removal of the circuit board, and improving the yield of the display panel 100. In another aspect, the bonding portion 123a is divided into the third sub-bonding portion 1231 and the fourth sub-bonding portion 1232, at least one sub-bonding portion 123a1 of the third sub-bonding portion 1231 and the fourth sub-bonding portion 1232 is connected to the non-bonding portion 123b of the third line segment 123, the third sub-bonding portion 1231 and the fourth sub-bonding portion 1232 are separated by the second isolation region G2, and the third sub-bonding portion 1231 and the fourth sub-bonding portion 1232 of the bonding portion 123a are both connected to the circuit board. When the circuit board is removed along the first direction X, if the third sub-bonding portion 1231 falls off together with the removal of the circuit board, and the fourth sub-bonding portion 1232 is retained on the second main surface 11b of the substrate 11, it may be possible to avoid the entire bonding portion 123a falling off. That is, even if one sub-bonding portion 123a1 in the third sub-bonding portion 1231 and the fourth sub-bonding portion 1232 falls off, the remaining sub-bonding portion 123a1 is still attached to the second main surface 11b and is connected to the non-bonding portion 123b of the third line segment 123 to transmit electrical signals, preventing the third line segment 123 from being disconnected to affect the quality of the display panel.

In some embodiments, as shown in FIG. 6B, a distance s1 between two adjacent bonding portions 123a is greater than or equal to a dimension s2 of the second isolation region G2 in the first direction X.

For example, referring to FIGS. 6A and 6B, since the bonding portion 123a had a certain dimension in the first direction X, in order to ensure that the second isolation region G2 is capable of separating the third sub-bonding portion 1231 and the fourth sub-bonding portion 1232, the dimension of the second isolation region G2 in the first direction X only needs to ensure that a contact area of a respective bonding electrode 151 connected to each of the third sub-bonding portion 1231 and the fourth sub-bonding portion 1232 is within a normal range, and ensure that the contact resistances between the bonding portion 123a and the bonding electrodes 151 meet the electrical requirements. Therefore, the distance s1 between the two bonding portions 123a is set to be greater than or equal to the dimension s2 of the second isolation region G2 in the first direction X. In some embodiments, the second isolation region G2 may be manufactured by laser etching a specific region of the metal coating.

In some embodiments, as shown in FIG. 6B, the dimension s2 of the second isolation region G2 in the first direction X is in a range of 10 µm to 30 µm, inclusive.

For example, the dimension s2 of the second isolation region G2 in the first direction X may be 10 µm, 20 µm, or 30 µm.

In some embodiments, a dimension of a bonding electrode 151 in the first direction X is less than or equal to a dimension of a sub-bonding portion 123a1 correspondingly connected thereto in the first direction X, and the sub-bonding portion 123a1 is the third sub-bonding portion 1231 or the fourth sub-bonding portion 1232.

For example, referring to FIG. 8B, the dimension of the bonding electrode 151 in the first direction X is B1, and the dimension of the sub-bonding portion 123a1 in the first direction X is L1, where B1 < L1, and the sub-bonding portion 123a1 is any one of the third sub-bonding portion 1231 and the fourth sub-bonding portion 1232.

For example, referring to FIG. 8C, the dimension of the bonding electrode 151 in the first direction X is B1, and the dimension of the sub-bonding portion 123a1 in the first direction X is L1, where B1 = L1, and the sub-bonding portion 123a1 is any one of the third sub-bonding portion 1231 and the fourth sub-bonding portion 1232.

With the above arrangement, it may be possible to ensure that an overlapping area of the bonding electrode 151 and the sub-bonding portion 123a1 is as close as possible to a surface area of the bonding electrode 151, thereby ensuring sufficient contact and bonding between the bonding electrode 151 and the sub-bonding portion 123a1, and reducing the contact resistance between the two, so that the electrical signals may be transmitted efficiently.

In some embodiments, the third sub-bonding portion 1231 and the fourth sub-bonding portion 1232 have the same dimension in the first direction X.

For example, referring to FIG. 6B, a dimension d0 of the third sub-bonding portion 1231 in the first direction X is equal to a dimension d0' of the fourth sub-bonding portion 1232 in the first direction X. That is to say, the bonding portion 123a is evenly divided into two portions, which are the third sub-bonding portion 1231 and the fourth sub-bonding portion 1232.

In some embodiments, the following determination rule may be referred to for determining whether the manner of dividing the bonding portion 123a into two sub-bonding portions 123a1 is selected by arranging the first isolation region or by arranging the second isolation region: in a case where a ratio of the dimension d1 of the bonding portion 123a in the first direction X to the dimension B1 of the corresponding bonding electrode in the first direction X (i.e., d1/B1) is in a range of 1 to 1.3, inclusive, the first isolation region is arranged for the bonding portion 123a, so as to divide the bonding portion 123a into the first sub-bonding portion and the second sub-bonding portion. This is because in the case where the ratio d1/B1 is in the range of 1 to 1.3, it indicates that dimensions of the bonding portion and the bonding electrode in the first direction X are not much different, and it is preferable to arrange the first isolation region extending along the first direction X in the bonding portion 123a, so that the first sub-bonding portion and the second sub-bonding portion are arranged along the second direction Y.

In a case where the ratio of the dimension d1 of the bonding portion 123a in the first direction X to the dimension B1 of the corresponding bonding electrode in the first direction X (i.e., d1/B1) is in a range of 2 to 3, inclusive, the second isolation region is arranged for the bonding portion 123a, so as to divide the bonding portion 123a into at least two sub-bonding portions extending along the second direction Y, for example, the bonding portion 123a is divided into the third sub-bonding portion and the fourth sub-bonding portion. This is because in the case where the ratio d1/B1 is in the range of 2 to 3, that is, dimensions of the bonding portion and the bonding electrode in the first direction X are much different, each bonding portion is capable of connecting to at least two bonding electrodes, therefore, it is preferable to arrange the second isolation region G2 for the bonding portion 123a. In this case, the bonding portion may include [d1/B1] sub-bonding portions arranged along the first direction X, and different sub-bonding portions are connected to different bonding portions in one-to-one correspondence. The [d1/B1] represents the quotient of d1 and B1 rounded down to an integer. Furthermore, on the basis of arranging the second isolation region G2, the first isolation region G1 may also be arranged. In this case, the bonding portion is divided into multiple sub-portions.

As shown in FIGS. 7E and 7F, in some embodiments of the present disclosure, the first implementation and the second implementation of Scheme 2 can be combined with each other.

In some embodiments, referring to FIGS. 7E and 7F, the dimension d1 of the bonding portion 123a of the third line segment 123 along the first direction X is equal to the dimension d2 of the non-bonding portion 123b along the first direction X, and the first direction X is the direction in which the plurality of third line segments 123 are arranged. A bonding portion 123a of at least one third line segment 123 includes four sub-portions, which are a first sub-portion 1a, a second sub-portion 1b, a third sub-portion 1c, and a fourth sub-portion 1d respectively. The four sub-portions are separated by a first isolation region G1 and a second isolation region G2. The first sub-portion 1a and the second sub-portion 1b form a first sub-bonding portion 123aa; the third sub-portion 1c and the fourth sub-portion 1d form a second sub-bonding portion 123ab; the first sub-portion 1a and the third sub-portion 1c form a third sub-bonding portion 1231; and the second sub-portion 1b and the fourth sub-portion 1d form a fourth sub-bonding portion 1232; and the first sub-portion 1a and the second sub-portion 1b are both connected to the non-bonding portion 123b of the third line segment 123.

For example, as shown in FIGS. 7E and 7F, the dimension of the bonding portion 123a of the third line segment 123 along the first direction X is d1, and the dimension of the non-bonding portion 123b of the third line segment 123 along the first direction X is d2, where d1 = d2. Referring to FIG. 7F, the bonding portion 123a of each of the plurality of third line segments 123 includes four sub-portions. The first sub-portion 1a and the second sub-portion 1b are proximate to the selected side surface 11cc, and connected to the non-bonding portion 123b of the third line segment 123; and the third sub-portion 1c and the fourth sub-portion 1d are disposed on a side of the third line segment 123 away from the selected side surface 11cc.

In some embodiments, the bonding portion 123a of at least one third line segment 123 includes four sub-portions, and the bonding portion 123a is electrically connected to two bonding electrodes of the circuit board, in which one of the two bonding electrodes is electrically connected to the first sub-portion 1a and the third sub-portion 1c, and the other bonding electrode is electrically connected to the second sub-portion 1b and the fourth sub-portion 1d.

In some examples, the first sub-portion 1a and the second sub-portion 1b have the same area, and the third sub-portion 1c and the fourth sub-portion 1d have the same area, where the area of the first sub-portion 1a is greater than the area of the third sub-portion 1c.

The above embodiment is a combination of the two implementations of Scheme 2, and dimension requirements of the first sub-portion 1a, the second sub-portion 1b, the third sub-portion 1c, and the fourth sub-portion 1d of the bonding portion 123a can refer to the description of the first sub-bonding portion 123aa, the second sub-bonding portion 123ab, the third sub-bonding portion 1231, and the fourth sub-bonding portion 1232.

These embodiments have the effects of the two implementations of Scheme 2. During the manufacturing process of the display panel, especially during the process of removing and re-bonding the circuit board, it may be possible to occur the risk of the bonding portion 123a falling off, this further affects the manufacturing process and the quality of the display panel 100 finally obtained. The bonding portion 123a is divided into the first sub-portion 1a, the second sub-portion 1b, the third sub-portion 1c, and the fourth sub-portion 1d, and a hollowed-out region K (composed of the first isolation region G1 and the second isolation region G2) is arranged between the four sub-portions, the hollowed-out region K is capable of separating the four sub-portions. In an aspect, it may be possible to ensure that the bonding portion 123a has a relatively small contact area with the second main surface 11b, so the presence of foreign matters between the bonding portion 123a and the second main surface 11b is relatively reduced, which may reduce the possibility of the bonding portion 123a falling off during the manufacturing process of the display panel. In another aspect, since areas of orthographic projections of the first sub-portion 1a and the second sub-portion 1b on the second main surface 11b are greater than areas of orthographic projections of the third sub-portion 1c and the fourth sub-portion 1d on the second main surface 11b, the third sub-portion 1c and the fourth sub-portion 1d are more easily falling off than the first sub-portion 1a and the second sub-portion 1b. The hollowed-out region K is capable of separating the four sub-portions, which can protect the first sub-portion 1a and the second sub-portion 1b while the third sub-portion 1c and the fourth sub-portion 1d falling off, thereby reducing the risk of the first sub-portion 1a and the second sub-portion 1b falling off during the removal of the circuit board. Moreover, the first sub-portion 1a and the second sub-portion 1b are both connected to the non-bonding portion 123b of the third line segment 123, and the first sub-portion 1a and the second sub-portion 1b are separated by the hollowed-out region K. In this way, during the process of continuing to remove the circuit board, in a case where one of the first sub-portion 1a and the second sub-portion 1b falls off together with the removal of the circuit board, the other sub-portion is still attached to the second main surface 11b, and is connected to the non-bonding portion 123b of the third line segment 123 to transmit electrical signals, it may be possible to avoid the third line segment 123 being disconnected and affecting the yield of the display panel.

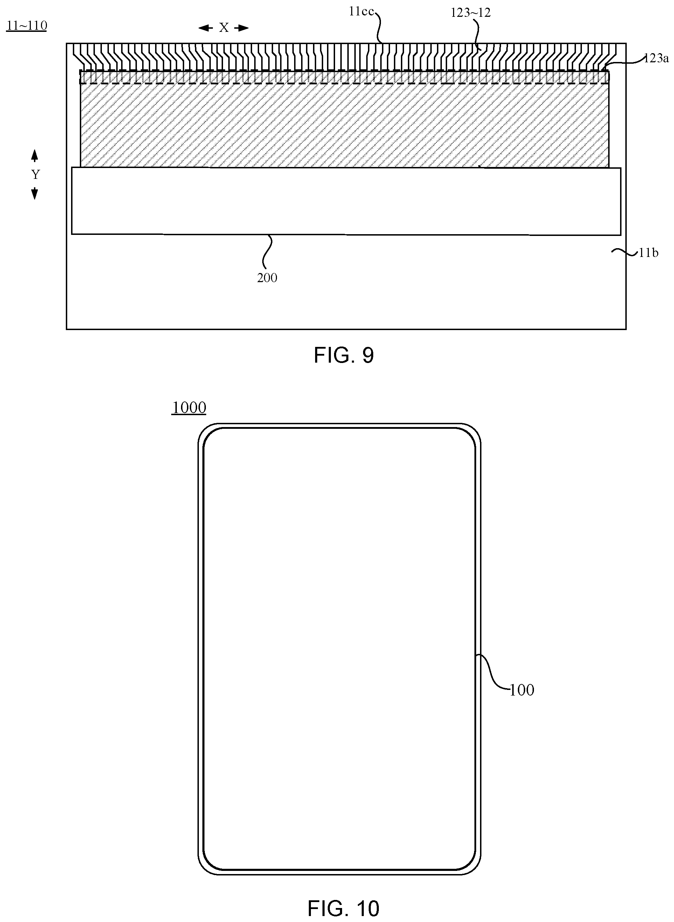

As shown in FIGS. 9 and 10, some embodiments of the present disclosure provide a display device 1000, including the display panel 100 provided in any of the above embodiments and a driving circuit board 200. The driving circuit board 200 is disposed on the second main surface 11b of the substrate 11 of the display panel 100, and the driving circuit board 200 is electrically connected to the plurality of connection lines 12 of the display panel 100 through the circuit board 15.

For example, as shown in FIG. 9, the driving circuit board 200 is connected to one end of the circuit board 15, and the other end of the circuit board 15 is connected to the bonding portions 123a of the third line segments 123 of the plurality of connection lines 12.

For example, the display device 1000 may be a mini light-emitting diode (Mini LED) display device, or the display device 1000 may be a micro light-emitting diode (Micro LED) display device.

Referring to FIGS. 9 and 10, the driving circuit board 200 is bonded to the side of the non-display surface of the display panel 100, that is to say, the driving circuit board 200 is bonded to the second main surface 11b of the substrate 11. The electronic element 14 located at the side of the display surface of the display panel 100 (the first main surface 11a of the substrate 11) is electrically connected to the driving circuit board 200 through the first line segments 121, the second line segments 122 and the third line segments 123. In this way, the frame of the display device 1000 may be reduced, and a screen-to-body ratio of the display device 1000 may be increased, thereby facilitating the realization of a seamless tiling effect.

In some examples, as shown in FIG. 1, a mini-light emitting diode or a micro-light emitting diode is adopted as the electronic element 14, which occupies a smaller volume and has a smaller particle compared to a conventional LED. Within the same screen size, the higher density of light sources per unit area and the smaller unit size of the light sources enable more precise localized control of the electronic element 14, which can ensure the uniformity of the display brightness, thereby ensuring the display quality of the display device 1000.

The display device 1000 adopts the display panel 100 provided in the above embodiments, and has the same technical effect as the above-described display panel 100, which will not be repeated herein.

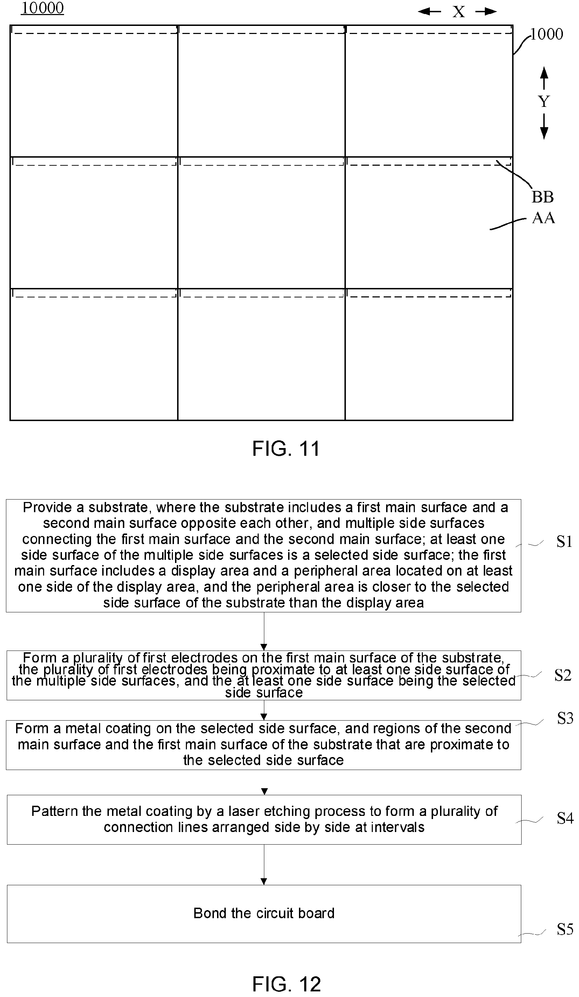

Some embodiments of the present disclosure provide a titled display device 10000, as shown in FIG. 11, the titled display device 10000 includes a plurality of display device 1000 provided by the above embodiments.

For example, the plurality of display devices 1000 in the titled display device 10000 are arranged in an array. The titled display device 10000 can realize the display of a relatively large picture, and the titled display device 10000 may be used as an advertising titled screen, a conference titled screen.

For example, as shown in FIG. 11, a planar shape of the display device 1000 is a rectangle.

Referring to FIGS. 11 and 1, in the display panel 100, the plurality of first electrodes 13 are arranged side by side along the first direction X, correspondingly, the plurality of connection lines 12 are also arranged side by side along the first direction X. The other direction parallel to the display surface of the display device 1000 and perpendicular to the first direction X is referred to as the second direction Y. The display device 1000 includes multiple side surfaces. In the following description, a side surface proximate to the peripheral area BB of the substrate 11 in the multiple side surfaces of the display device 1000 is referred to as a selected side surface of the display device 1000.

For example, as shown in FIG. 1, the display panel 100 includes a display area AA and a peripheral area BB located on a side of the display area AA, and the plurality of connection lines 12 and the plurality of first electrodes 13 are arranged proximate to the peripheral area BB of the substrate 11.

Further, as shown in FIG. 11, when the plurality of display devices 1000 each including the display panel 100 as shown in FIG. 1 are tiled, selected side surfaces of two adjacent display devices 1000 are arranged along the first direction X. In this way, among multiple display devices 1000 arranged in a row along the first direction X, there is substantially no tiling seam between the two adjacent display devices 1000 along the first direction X, and there is a tiling seam between two adjacent display devices 1000 among multiple display devices 1000 arranged in a column along the second direction Y. That is to say, a dimension of the tiling seam between the two adjacent display devices among the multiple display devices 1000 arranged in the row along the first direction X is less than a dimension of the tiling seam between the two adjacent display devices 1000 among the multiple display devices 1000 arranged in the column along the second direction Y.

However, since a dimension of the peripheral area BB in the second direction Y is very small, when the titled display device 10000 is actually viewed, the tiling seam between the two adjacent display devices 1000 is difficult to be noticed with the naked eye within a viewing distance, thereby making a display image of the titled display device 10000 relatively complete, presenting a relatively good display effect.

The titled display device 10000 uses the display device 1000 provided by the above embodiments, which has the same technical effects as the above display device 1000, which will not be detailed here.

Furthermore, a manufacturing method of a display panel 100 is provided.

The manufacturing method of the display panel 100, as shown in FIG. 12, includes steps S1 to S5.

In S1, a substrate 11 is provided.

As shown in FIG. 1, the substrate 11 includes a first main surface 11a and a second main surface 11b opposite each other, and multiple side surfaces 11c connecting the first main surface 11a and the second main surface 11b. At least one side surface 11c of the multiple side surfaces 11c is a selected side surface 11cc. The first main surface 11a includes a display area AA and a peripheral area BB located on at least one side of the display area AA, and the peripheral area BB is closer to the selected side surface 11cc of the substrate 11 than the display area AA.

In some examples, a material of the substrate 11 may be a rigid material such as glass or quartz.

In S2, a plurality of first electrodes 13 are formed on the first main surface 11a of the substrate 11, the plurality of first electrodes 13 are proximate to at least one side surface 11c of the multiple side surfaces 11c, and the at least one side surface 11c is the selected side surface 11cc.

Referring to FIG. 1, at least one side surface 11c is used for arranging side surfaces of a plurality of connection lines 12 thereon in subsequent steps, and the at least one side surface 11c is referred to as the selected side surface 11cc; and the plurality of first electrodes 13 are proximate to a side connected to the selected side surface 11cc among sides of the first main surface 11a.

In some embodiments, referring to FIG. 2, S2 further includes forming a driving circuit layer 17 on the first main surface 11a of the substrate 11, where the driving circuit layer 17 includes a plurality of signal lines, and the plurality of signal lines are located in the display area AA. The plurality of first electrodes 13 are located in the peripheral area BB, and each signal line is electrically connected to a first electrode 13.

In S3, referring to FIG. 3A, a metal coating 16 is formed on the selected side surface 11cc, and regions of the second main surface 11b and the first main surface 11a of the substrate 11 that are proximate to the selected side surface 11cc.

For example, in the above step, the metal coating 16 is formed by a sputtering coating process, specifically, a physical vapor deposition (PVD) sputtering coating process.

In some embodiments, the metal coating formed by the sputtering process is, for example, a copper layer. Using copper as the material for the metal coating makes it possible to have good electrical conductivity of the metal coating while having a low manufacturing cost.

As a possible design, the metal coating 16 has a multi-layer structure. For example, the metal coating formed by the sputtering process includes a titanium layer, a copper layer, and another titanium layer formed by sputtering sequentially away from the substrate 11. Here, by forming the titanium layers on a side of the copper layer proximate to the substrate 11 and on a side away from the substrate 11, the copper layer is encapsulated therein. In this way, the copper layer can be effectively prevented from oxidizing, due to the corrosion-resistant properties of the titanium metal, thereby playing a protective effect on the copper layer, and effectively avoiding corrosion of the connection lines formed by the metal coating 16, which affects the normal functioning of the lines.

In S4, the metal coating 16 is patterned by a laser etching process to form a plurality of connection lines 12 arranged side by side at intervals.

As shown in FIGS. 2 and 3A, each connection line 12 of the plurality of connection lines 12 includes a first line segment 121, a second line segment 122, and a third line segment 123 that are connected in sequence. The first line segment 121 is arranged on a side of the first main surface 11a proximate to the selected side surface 11cc, and the first line segment 121 is electrically connected to one of the plurality of first electrodes 13; the second line segment 122 is arranged on the selected side surface 11cc; and the third line segment 123 is located on the second main surface 11b. The third line segment 123 includes a bonding portion 123a and a non-bonding portion 123b, where the bonding portion 123a is farther away from the selected side surface 11cc relative to the non-bonding portion 123b.

In the above step, as shown in FIG. 3A, the plurality of connection lines 12 formed by laser etching the metal coating 16 are independently separated, and there is a spacing region Q between any two of the plurality of connection lines 12. During the laser etching process, a portion of the metal coating 16 located in each spacing region Q is removed to form the plurality of connection lines 12.

For example, referring to FIG. 4B, a dimension of the bonding portion 123a of the third line segment 123 in the first direction X is less than a dimension of the non-bonding portion 123b of the third line segment 123 in the first direction X. That is to say, in S4, during the process of laser etching the spacing region Q of the metal coating 16, a dimension T of a portion of the spacing region Q located between bonding portions 123a of two adjacent third line segments 123 in the first direction X is greater than a dimension s1 of a portion of the spacing region Q located between non-bonding portions 123b of the two adjacent third line segments 123 in the first direction X, which is equivalent to widening a region of the laser etching when the laser etching is made to the position of the bonding portion 123a of the third segment line 123, thereby ensuring that an area of the bonding portion 123a is reduced, and the contact area between the second main surface 11b and the bonding portion 123a is reduced, reducing the risk of the bonding portion 123a of the third line segment 123 falling off during the removal of the circuit board, further improving the yield of the display panel 100.

In some embodiments, referring to FIGS. 4A to 6B, the above step S4 further includes a step S41.

In S41, portions of the metal coating 16 located in the first isolation region G1 and/or the second isolation region G2 are removed by the laser etching process.

For example, referring to FIGS. 5B, 5C and 6B, the first isolation region G1 formed in the above step extends along the first direction X, and the second isolation region G2 formed in the above step extends along the second direction Y. There is no metal coating in the first isolation region G1 and the second isolation region G2, and the second main surface 11b is exposed in the first isolation region G1 and the second isolation region G2.

In some embodiments, referring to FIGS. 5B and 5C, the first isolation region G1 formed divides the bonding portion 123a of the third line segment 123 into a first sub-bonding portion 123aa and a second sub-bonding portion 123ab, and there is no electrical relationship between the first sub-bonding portion 123aa and the second sub-bonding portion 123ab. Areas of orthographic projections of the first sub-bonding portion 123aa and the second sub-bonding portion 123ab on the second main surface 11b are not equal, and the area of the first sub-bonding portion 123aa is greater than the area of the second sub-bonding portion 123ab, and the first sub-bonding portion 123aa is closer to the selected side surface 11cc than the second sub-bonding portion 123ab. During the manufacturing process of the display panel 100, especially during the process of removing and re-bonding the circuit board, it is easy to occur the risk that the entire bonding portion 123a falls off, further affecting the manufacturing process and the quality of the display panel 100 finally obtained. The first isolation region G1 is formed between the first sub-bonding portion 123aa and the second sub-bonding portion 123ab, in an aspect, the contact area between the second main surface 11b and the bonding portion 123a can be reduced; in another aspect, a bonding electrode of the circuit board is connected to the first sub-bonding portion 123aa and the second sub-bonding portion 123ab of the bonding portion, during the process of removing the circuit board, the second sub-bonding portion 123ab is sacrificed to fall off together with the removal of the circuit board, so that adhesion of the circuit board to the first sub-bonding portion 123aa is weak, the first sub-bonding portion is retained, thereby reducing the risk of the entire bonding portion 123a of the third line segment 123 falling off during the process of removing the circuit board. Furthermore, a portion of the third line segment that plays a role in connecting lines and transmitting signals is the first sub-bonding portion, so even if the second sub-bonding portion falls off, there is no open circuit, thereby reducing damage to the product caused by the bonding portion 123a falling off during the manufacturing process of the display panel 100, and improving the yield of the product.

In some embodiments, referring to FIG. 6B, the formed second isolation region G2 divides the bonding portion 123a of the third line segment 123 into a third sub-bonding portion 1231 and a fourth sub-bonding portion 1232, and the third sub-bonding portion 1231 and the fourth sub-bonding portion 1232 are both connected to the non-bonding portion 123b, ensuring that the circuit board can realize bonding effect with the third line segment 123 through both the third sub-bonding portion 1231 and the fourth sub-bonding portion 1232. Therefore, in an aspect, the second isolation region G2 reduces the contact area between the second main surface 11b and the bonding portion 123a, and reduces the risk of the bonding portion 123a of the third line segment 123 falling off during the process of removing the circuit board; in another aspect, it can be ensured that during the process of removing the circuit board, even if one of the third sub-bonding portion 1231 and the fourth sub-bonding portion 1232 falls off, the other sub-bonding portion may still be retained, in this way, when the circuit board is re-bonded, except the damaged third sub-bonding portion 1231, the other sub-bonding portion 123a1 has a complete shape and function, thereby ensuring the normal connection and signal transmission between the circuit board and the plurality of connection lines, so that the display panel 100 will not be damaged, improving the yield of the display panel 100.

In S5, as shown in FIGS. 8A, 8B and 8C, the circuit board 15 is bonded.

For example, the circuit board 15 includes a plurality of bonding electrodes 151, and each of the plurality of bonding electrodes 151 is electrically connected to a bonding portion 123a of a third line segment 123 of the plurality of third line segments 123.

It will be noted that bonding the circuit board 15 in this step is a formal bonding step after cleaning the third line segment 123.

In some embodiments, referring to FIG. 2, after S4, the manufacturing method further includes: arranging a plurality of electronic elements 14 on a side of the driving circuit layer 17 away from the substrate 11.

For example, the electronic element 14 includes a light-emitting device. A die bonding process may be used for transferring the plurality of electronic elements 14 to the side of the driving circuit layer 17 away from the substrate 11. The driving circuit layer 17 is coupled to the plurality of electronic elements 14 and is configured to drive a plurality of electronic elements 14 to emit light.

In some examples, the first main surface 11a of the display panel 100 includes a display area AA and at least one peripheral area BB located around the display area AA. The plurality of electronic elements 14 are located in the display area AA. For example, the plurality of electronic elements 14 include sub-pixels P of at least three colors, the sub-pixels P of the multiple colors are a plurality of sub-pixels, and the plurality of sub-pixels include at least sub-pixels of a first color, sub-pixels of a second color, and sub-pixels of a third color, where the first color, the second color and the third color are three primary colors (e.g., red, green and blue). For example, each sub-pixel includes at least one electronic element 14.

In the display panel 100 obtained by the manufacturing method of the display panel provided by some embodiments of the present disclosure, referring to FIGS. 5B, 5C and 6B, a first isolation region G1 or a second isolation region G2 is arranged between two sub-bonding portions 123a1 of a bonding portion 123a of at least one third line segment 123, the first isolation region G1 or the second isolation region G2 is configured to separate the two sub-bonding portions 123a1, which means that the bonding portion 123a has a certain gap therein, and the bonding portion 123a is then bonded to the circuit board. During the manufacturing process of the display panel, especially during the manual or mechanical cleaning and tearing processes, the circuit board is forced to separate from the bonding portion 123a, the bonding portion 123a corresponding to the circuit board can be prevented from being associated tear-off damage, thereby reducing the manufacturing cost of the display panel, and improving the yield and service life of the display panel 100.

The foregoing descriptions are merely specific implementations of the present disclosure, but the protection scope of the present disclosure is not limited thereto. Changes or replacements that any person skilled in the art could conceive of within the technical scope of the present disclosure shall be included in the protection scope of the present disclosure. Therefore, the protection scope of the present disclosure shall be subject to the protection scope of the claims.

## Claims

1. A display panel, comprising:
a substrate, the substrate including a first main surface and a second main surface opposite each other, and multiple side surfaces connecting the first main surface and the second main surface, wherein at least one side surface of the multiple side surfaces is a selected side surface;
a plurality of electronic elements disposed on the first main surface of the substrate;
a plurality of first electrodes disposed on the first main surface of the substrate, wherein the plurality of first electrodes are closer to the selected side surface than the plurality of electronic elements, and the plurality of first electrodes are electrically connected to the plurality of electronic elements; and
a plurality of connection lines, the plurality of connection lines being arranged side by side at intervals, wherein each connection line of the plurality of connection lines includes a first line segment, a second line segment and a third line segment that are connected in sequence; the first line segment is disposed on the first main surface, and electrically connected to one of the plurality of first electrodes, the second line segment is disposed on the selected side surface, and the third line segment is disposed on the second main surface; the third line segment includes a bonding portion and a non-bonding portion, and the bonding portion is farther away from the selected side surface relative to the non-bonding portion; and bonding portions of a plurality of third line segments are used for bonding a circuit board;
wherein a maximum dimension of the bonding portion of the third line segment along a direction perpendicular to an extension direction of the bonding portion is less than a maximum dimension of the non-bonding portion along a direction perpendicular to an extension direction of the non-bonding portion; and/or in the plurality of third line segments, a bonding portion of at least one third line segment includes at least two sub-bonding portions, and at least one sub-bonding portion of the two sub-bonding portions is connected to a non-bonding portion of the third line segment.

2. The display panel according to claim 1, wherein for the third line segment, a difference between the maximum dimension of the bonding portion along the direction perpendicular to the extension direction thereof and the maximum dimension of the non-bonding portion along the direction perpendicular to the extension direction thereof is in a range of 20 µm to 50 µm, inclusive.

3. The display panel according to claim 2, wherein a dimension of the bonding portion in a first direction is greater than or equal to 80 µm, the first direction being a direction in which the plurality of third line segments are arranged.

4. The display panel according to claim 3, wherein a distance between two adjacent bonding portions is in a range of 40 µm to 110 µm, inclusive.

5. The display panel according to claim 4, wherein two opposite side edges of a portion, connected to the bonding portion, of the non-bonding portion in the first direction are a first side edge and a second side edge; two opposite sides of the bonding portion in the first direction are a third side edge and a fourth side edge; and the first side edge and the third side edge are located at a same side, and the second side edge and the fourth side edge are located at a same side; and
a distance between the first side edge and the third side edge is equal to a distance between the second side edge and the fourth side edge.

6. The display panel according to any one of claims 1 to 5, wherein the bonding portion of the third line segment includes a first sub-bonding portion and a second sub-bonding portion, the first sub-bonding portion is connected to the non-bonding portion, and the first sub-bonding portion and the second sub-bonding portion are provided with a first isolation region therebetween; and
an area of the first sub-bonding portion is greater than an area of the second sub-bonding portion.

7. The display panel according to claim 6, wherein the bonding portions of the plurality of third line segments each include a first sub-bonding portion and a second sub-bonding portion, a first isolation region corresponding to each of the bonding portions extends along a first direction, and a plurality of first isolation regions have a same dimension in a second direction, and the plurality of first isolation regions have a same distance from the selected side surface, wherein the second direction is perpendicular to the first direction.

8. The display panel according to claim 7, wherein a dimension of the first isolation region in the second direction is in a range of 15 µm to 30 µm, inclusive.

9. The display panel according to any one of claims 6 to 8, wherein a ratio of a dimension of the second sub-bonding portion in a second direction to a dimension of the first sub-bonding portion in the second direction is in a range of 0.08 to 0.1, inclusive, the second direction being perpendicular to a first direction.

10. The display panel according to any one of claims 1 to 9, wherein the circuit board includes a plurality of bonding electrodes arranged at intervals along a first direction, and each bonding portion is connected to at least one bonding electrode; and
a dimension of the bonding portion in the first direction is greater than or equal to 150 µm, and the bonding portion is connected to two adjacent bonding electrodes of the circuit board.

11. The display panel according to claim 10, wherein
the bonding portion of the third line segment includes a third sub-bonding portion and a fourth sub-bonding portion, the third sub-bonding portion and the fourth sub-bonding portion are provided with a second isolation region therebetween, and the third sub-bonding portion and the fourth sub-bonding portion are both connected to the non-bonding portion; and
the third sub-bonding portion and the fourth sub-bonding portion are connected to the two bonding electrodes respectively.

12. The display panel according to claim 11, wherein a distance between the two adjacent bonding portions is greater than or equal to a dimension of the second isolation region in the first direction.

13. The display panel according to claim 12, wherein a dimension of the second isolation region in the first direction is in a range of 10 µm to 30 µm, inclusive.

14. The display panel according to any one of claims 11 to 13, wherein for a bonding electrode and a sub-bonding portion connected in correspondence, a dimension of the bonding electrode in the first direction is less than or equal to a dimension of the sub-bonding portion in the first direction; and the sub-bonding portion is the third sub-bonding portion or the fourth sub-bonding portion.

15. The display panel according to claim 14, wherein dimensions of the third sub-bonding portion and the fourth sub-bonding portion in the first direction are equal.

16. The display panel according to any one of claims 1 to 15, wherein a ratio of a dimension of the bonding portion of the third line segment in a second direction to a dimension of the third line segment in the second direction is in a range of 0.4 to 0.5, inclusive.

17. The display panel according to claim 16, wherein the third line segment includes a first sub-line segment, a second sub-line segment and a third sub-line segment that are connected in sequence, and the first sub-line segment is proximate to the selected side surface;
first sub-line segments of the plurality of connection lines are arranged at intervals along a first direction, and third sub-line segments of the plurality of connection lines are arranged at intervals along the first direction; an extension direction of the first sub-line segment intersects an extension direction of the second sub-line segment, and the extension direction of the second sub-line segment intersects an extension direction of the third sub-line segment; and the first sub-line segment and the second sub-line segment are connected through a first connection portion, and the second sub-line segment and the third sub-line segment are connected through a second connection portion;
the bonding portion is the third sub-line segment; and the non-bonding portion is the first sub-line segment, the first connection portion, the second sub-line segment, and the second connection portion; and
a boundary line of an orthographic projection of the second connection portion on the second main surface is in a shape of a curve.

18. A display device, comprising:
the display panel according to any one of claims 1 to 17; and
a driving circuit board, the driving circuit board being disposed on the second main surface of the substrate of the display panel, and electrically connected to a circuit board and the plurality of connection lines of the display panel.

19. A tiled display device, comprising a plurality of display devices each according to claim 18, the plurality of display devices being tiled and assembled.

20. A manufacturing method of a display panel, comprising:
providing a substrate, the substrate including a first main surface and a second main surface opposite each other, and multiple side surfaces connecting the first main surface and the second main surface, wherein at least one side surface of the multiple side surfaces is a selected side surface;
forming a plurality of first electrodes on the first main surface of the substrate;
forming a plurality of connection lines on the first main surface, the second main surface and the selected side surface of the substrate, wherein the plurality of connection lines are arranged side by side at intervals; each connection line of the plurality of connection lines includes a first line segment, a second line segment and a third line segment that are connected in sequence; the first line segment is disposed on a side of the first main surface proximate to the selected side surface, and electrically connected to one of the plurality of first electrodes, the second line segment is disposed on the selected side surface, and the third line segment is disposed on the second main surface; and the third line segment includes a bonding portion and a non-bonding portion, and the bonding portion is farther away from the selected side surface relative to the non-bonding portion; and
bonding a circuit board, the circuit board being electrically connected to third line segments of the plurality of connection lines;
wherein a maximum dimension of the bonding portion of the third line segment in a direction perpendicular to an extension direction of the bonding portion is less than a maximum dimension of the non-bonding portion in a direction perpendicular to an extension direction of the non-bonding portion, and a first direction is a direction in which the plurality of third line segments are arranged; and/or in the plurality of third line segments, a bonding portion of at least one third line segment includes at least two sub-bonding portions, and at least one sub-bonding portion of the two sub-bonding portions is connected to a non-bonding portion of the third line segment.
